# EUROPEAN PATENT APPLICATION

(11) **EP 4 415 168 A1**
(43) Date of publication of application: **14.08.2024**
(21) Application number: 21960002.0
(22) Date of filing: 07.10.2021
(51) Int. Cl.: H01Q 1/32, H01Q 1/38, H01Q 5/25, H04B 7/0413

(54) **WIDEBAND ANTENNA ARRANGED ON VEHICLE**

(71) Applicant: LG Electronics Inc., Yeongdeungpo-gu Seoul 07336 (KR)
(72) Inventor: YUN, Changwon, Seoul 06772 (KR); JEONG, Yiseon, Seoul 06772 (KR); JEON, Cheolsoo, Seoul 06772 (KR)
(74) Representative: Vossius & Partner Patentanwälte Rechtsanwälte mbB
(86) International application number: PCT/KR2021/013780
(87) International publication number: WO 2023/058790

(57) **Abstract**

An antenna module mounted on a vehicle is provided. The antenna module includes a PCB having a transmission line formed therein; an antenna PCB coupled to the PCB and having a power supply pattern formed on one surface thereof and a metal pattern formed at at least one of one side and the other side of the power supply pattern; and a filter unit configured to electrically connect the metal pattern to a ground pattern of the PCB in a specific band. The antenna PCB includes a slot radiator configured to radiate a wireless signal through a slot region formed by a first length in a first axis direction inside the metal pattern.

## Description

### Technical Field

This specification relates to a wideband antenna disposed in a vehicle. One particular implementation relates to an antenna module having a wideband antenna that is capable of operating in various communication systems, and to a vehicle having the same.

### Background Art

A vehicle may perform wireless communication services with other vehicles or nearby objects, infrastructures, or a base station. In this regard, various communication services may be provided using Long Term Evolution (LTE) communication, 5G communication, or WiFi communication technology.

In order to provide these various wireless communication services in a vehicle, an antenna may be disposed on a glass of the vehicle, above or below a roof of the vehicle. When the antenna is disposed on the glass of the vehicle, it may be implemented with a transparent antenna material. Meanwhile, when the antenna is disposed above or below the roof of the vehicle, an effect on a vehicle body and the roof of the vehicle may cause a change in antenna performance.

In this regard, there is a problem in that the vehicle body and the vehicle roof are formed of a metallic material to block radio waves. Accordingly, a separate antenna structure may be disposed above the vehicle body or the roof. Or, when the antenna structure is disposed below the vehicle body or roof, a portion of the vehicle body or roof corresponding to a region where the antenna structure is disposed may be formed of a non-metallic material.

Meanwhile, in order to provide WiFi communication services in a vehicle, a WiFi communication antenna needs to be provided in the vehicle. In relation to these WiFi communication services, the vehicle WiFi antenna needs to be configured to operate in a 5 GHz band and a 6 GHz band in addition to a 2.4 GHz band. In this regard, existing antenna elements are implemented as resonance antenna elements with a limited bandwidth, so there is a problem in that bandwidth characteristics are limited.

In addition, a vehicle antenna needs to form an antenna beam within a predetermined angle range in a horizontal direction rather than a vertical direction. In this regard, an antenna beam pattern formed within a predetermined angle range in the horizontal direction may be referred to as a low elevation beam pattern. Meanwhile, there is a problem in that no specific structure for configuring the antenna element has been proposed to implement such a low elevation beam pattern.

### Disclosure of Invention

### Technical Problem

This specification is directed to solving the aforementioned problems and other drawbacks. In addition, another aspect of this specification is to provide a wideband antenna element capable of performing a wideband operation while being disposed in a vehicle.

Another aspect of this specification is to provide a wideband antenna element so as to implement Wi-Fi 6 and Wi-Fi 7 communication services in 5 GHz and 6 GHz bands in addition to the existing Wi-Fi band within the vehicle.

Another aspect of this specification is to provide a high-efficiency wideband antenna element having a high antenna gain while operating in a wide bandwidth.

Another aspect of this specification is to maintain antenna performance at a predetermined level even in a case where the exterior of a vehicle body or roof is made of a metallic material.

Another aspect of the present disclosure is to improve antenna performance of an antenna system while maintaining a height of the antenna system at a predetermined level or less.

Another aspect of the present disclosure is to provide a structure for mounting an antenna system, which is capable of operating in a broad frequency band to support various communication systems, to a vehicle.

### Solution to Problem

In order to achieve the foregoing or other objectives, an antenna module mounted on a vehicle according to an embodiment is provided. The antenna module may include a PCB having a transmission line disposed thereon; an antenna PCB coupled to the PCB, and disposed with a feed pattern on one surface thereof and a metal pattern disposed on at least one of one side and the other side of the feed pattern; and a filter part configured to electrically connect the metal pattern and a ground pattern of the PCB in a specific band. The antenna PCB may include a slot radiator configured to radiate a wireless signal through a slot region disposed to have a first length in a first axis direction inside the metal pattern.

According to an embodiment, the antenna PCB may further include a second radiator connected to an end portion of the feed pattern, and disposed in an upper region of the metal pattern in a second axis direction.

According to an embodiment, the slot radiator and the second radiator constitute a radiator module. The second radiator may include a first region connected to an end portion of the feed pattern, and configured to increase in width in the second axis direction; and a second region connected to an end portion of the first region in the second axis direction, the second region having a second length in the first axis direction and a second width in the second axis direction. The second radiator may be configured to radiate a wireless signal in a first band.

According to an embodiment, the direction of a first current formed in the second radiator and the direction of a second current formed in the ground pattern may be formed in the same direction such that the radiator module operates in a monopole mode. The ground pattern including the slot radiator may operate as a ground of the feed pattern that feeds the second radiator.

According to an embodiment, the second region may include a parasitic metal pattern disposed to extend a length of the second region to one side and the other side thereof from end portions of the first region in the first axis direction.

According to an embodiment, the slot radiator may be disposed to have a first length in a first axis direction with respect to a center point of the slot region, and configured to gradually increase in width in a second axis direction with respect to the center point. The slot radiator may be configured to radiate a wireless signal in a second band higher than the first band together with the radiator.

According to an embodiment, the direction of a first current formed in the second radiator may be different from the direction of a second current formed in the ground pattern, and a third current and a fourth current may be formed along a boundary of the slot region such that the radiator module operates in a mode combining a monopole mode and a slot mode. The directions of the third current and the fourth current formed in upper and lower regions of the metal pattern may be formed differently with respect to the boundary of the slot region.

According to an embodiment, the direction of a first current formed in the third radiator and the direction of a second current formed in the ground pattern may be formed differently. The radiator module may be configured to radiate a wireless signal through the slot radiator in a third band higher than the second band.

According to an embodiment, a third current and a fourth current may be formed along the boundary of the slot region such that the radiator module operates in a mode combining a monopole mode and a slot mode. The directions of the third current and the fourth current formed in upper and lower regions of the metal pattern may be formed in the same direction with respect to the boundary of the slot region.

According to an embodiment, the filter part may be configured to block a signal in a first band such that the metal pattern and the ground pattern of the PCB are not connected to each other in the first band. A signal in the first band applied through the feed pattern may be radiated through the second radiator.

According to an embodiment, the filter part may be configured to pass a signal in a second band higher than the first band such that the metal pattern and the ground pattern of the PCB are connected to each other in the second band. The signal in the second band applied through the feed pattern may be radiated through the slot radiator and the second radiator.

According to an embodiment, the filter part may be configured to pass a signal in a third band higher than the second band such that the metal pattern and the ground pattern of the PCB are connected to each other in the third band. The signal in the third band applied through the feed pattern may be radiated through the slot radiator.

According to an embodiment, the antenna PCB may be disposed perpendicular to the PCB, and an end portion of the feed pattern may be connected to the transmission line of the PCB through a conductive block coupled to the PCB. The ground pattern disposed on at least one side of the feed pattern may be connected to a ground of the PCB through the filter part and a conductive block coupled to the PCB.

According to an embodiment, the antenna PCB may be formed of a dielectric substrate, and the metal pattern may be disposed to extend from the one surface of the dielectric substrate to the other surface thereof along a lower surface. A hole may be disposed on the other surface of the dielectric substrate such that the dielectric substrate is fixed to the PCB through an insertion structure inserted into the hole.

According to an embodiment, the antenna PCB may be formed of a flexible substrate, and the metal pattern may be disposed to extend from the one surface of the flexible substrate to a protruding portion on the other surface thereof along a lower surface. The metal pattern may not be disposed on a flat portion of the other surface of the flexible substrate.

According to an embodiment, the antenna PCB may be implemented as a rib structure of a top cover of the antenna module or attached to the rib structure, and disposed to surround inner and outer regions of the rib structure of the metal pattern of the antenna PCB. The rib structure of the top cover may extend to the PCB so as to be coupled to conductive blocks on the PCB.

According to an embodiment, a wireless signal may be radiated to one surface and the other surface of the antenna PCB at an angle tilted by a predetermined angle in a vertical direction with respect to a bottom surface of a bottom cover of the antenna module. The wireless signal may be radiated in all directions in a horizontal direction with respect to the bottom surface of the bottom cover.

A vehicle having an antenna module according to another aspect of this specification is provided. The vehicle may include an antenna module disposed below a roof of the vehicle; and a processor disposed inside or outside the antenna module, and configured to communicate with at least one of an adjacent vehicle, a road side unit (RSU), and a base station. The antenna module may include a PCB having a transmission line disposed thereon; a bottom cover having the PCB disposed therein, the bottom cover configured to be attached to the vehicle; an antenna PCB coupled to the PCB, and disposed with a feed pattern on one surface thereof and a metal pattern disposed on at least one of one side and the other side of the feed pattern; and a filter part configured to electrically connect the metal pattern and a ground pattern of the PCB in a specific band.

According to an embodiment, the antenna PCB may include a slot radiator configured to radiate a wireless signal through a slot region disposed to have a first length in a first axis direction inside the metal pattern. The antenna PCB may further include a second radiator connected to an end portion of the feed pattern, and disposed in an upper region of the metal pattern in a second axis direction.

According to an embodiment, the slot radiator and the second radiator may constitute a radiator module. The second radiator may include a first region connected to an end portion of the feed pattern, and configured to increase in width in the second axis direction; and a second region connected to an end portion of the first region in the second axis direction, the second region having a second length in the first axis direction and a second width in the second axis direction. The second radiator may be configured to radiate a first signal in a first band, the slot radiator and the second radiator may be configured to radiate a second signal in a second band higher than the first band, and the slot radiator may be configured to radiate a third signal in a third band higher than the second band.

According to an embodiment, the processor may control the filter part to block a first signal in a first band such that the metal pattern and the ground pattern of the PCB are not connected to each other in the first band. The processor may control the filter part to connect the metal pattern and the ground pattern of the PCB in second and third bands higher than the first band such that a second signal in the second band and a third signal in the third band pass therethrough. The first signal in the first band applied through the feed pattern may be radiated through the second radiator, and the second signal in the second band applied through the feed pattern may be radiated through the slot radiator and the second radiator. The third signal in the third band applied through the feed pattern may be radiated through the slot radiator.

According to an embodiment, the antenna module may include a first antenna and a second antenna consisting of the slot radiator and the second radiator. The processor may control to perform multi-input multi-output (MIMO) in a first band through the first antenna and the second antenna. The processor may control to perform multi-input multi-output (MIMO) in a second band and a third band higher than the first band through the first antenna and the second antenna.

### Advantageous Effects of Invention

The technical effects of such an antenna module mounted on a vehicle and a vehicle equipped with the antenna module will be described as follows.

According to this specification, it aims to provide a multi-mode wideband antenna element capable of providing Wi-Fi communication services in various bands while being disposed in a vehicle.

According to this specification, an antenna element operating in a wide bandwidth may be implemented through a structure in which antenna elements operating in a monopole mode and a slot mode are connected to a feed line on a PCB.

According to this specification, a wideband antenna element with a high efficiency while operating in a wide bandwidth may be implemented through an antenna element operating in a monopole mode fed on a CPW transmission line and a slot mode having a bow-tie type slot shape.

According to this specification, a filter may be implemented to selectively connect ground patterns disposed on both sides of a feed line of an antenna PCB to a ground of the PCB, thereby implementing a wideband antenna operating in different modes in different bands.

According to this specification, a wideband antenna element may be disposed inside a non-metallic antenna module, thereby maintaining antenna performance at a predetermined level even when the exterior of a vehicle body or roof is formed of a metal material.

According to this specification, a structure for mounting an antenna system capable of operating in a wideband on a vehicle to support various communication systems may be presented.

Further scope of applicability of the present disclosure will become apparent from the following detailed description. It should be understood, however, that the detailed description and specific examples, such as the preferred embodiment of the disclosure, are given by way of illustration only, since various changes and modifications within the spirit and scope of the disclosure will be apparent to those skilled in the art.

### Brief Description of Drawings

FIG. 1A is a diagram illustrating an internal configuration of a vehicle in accordance with one example. FIG. 1B is a lateral view illustrating the vehicle interior in accordance with the one example.
FIG. 2A is a diagram illustrating a type of V2X application.
FIG. 2B is a view illustrating a standalone scenario supporting V2X SL communication and an MR-DC scenario supporting V2X SL communication.
FIGS. 3A to 3C are views illustrating a structure for mounting an antenna system in a vehicle, to which the antenna system is mounted.
FIG. 4 is a block diagram illustrating a vehicle and an antenna system mounted to the vehicle in accordance with one example.
FIG. 5 shows diagrams in which radiation patterns depending on whether a ground is disposed on a rear side of an antenna element are compared when the antenna element is disposed perpendicular to a horizontal plane.
FIG. 6 shows an exploded view of an antenna module having a wideband antenna according to this specification.
FIG. 7 shows a configuration in which an antenna PCB disposed with the wideband antenna of FIG. 6 is coupled to a PCB.
FIG. 8 shows structures of wideband antennas according to different embodiments.
FIG. 9 shows an equivalent circuit when a filter part is disposed in the wideband antenna structure of FIG. 7.
FIG. 10 is a conceptual diagram showing an operating principle for each band of the wideband antenna structure of FIGS. 7 to 9.
FIG. 11 shows a current distribution for each band of the antenna structure presented herein.
FIGS. 12A and 12B show antenna characteristics of the wideband antenna structure shown in FIG. 7 and (a) of FIG. 8.
FIGS. 13A to 13C show electric field distributions and radiation patterns of the wideband antenna structure according to this specification.
FIGS. 14A and 14B show a structure in a case where an antenna PCB disposed with a wideband antenna element is implemented on a dielectric substrate.
FIGS. 15A and 15B show a structure in a case where an antenna PCB disposed with a wideband antenna element is implemented on a flexible substrate.
FIGS. 16A and 16B show radiation patterns of a wideband antenna structure presented herein in vertical and horizontal directions.
FIG. 17 shows a configuration diagram of a vehicle in which an antenna module corresponding to an antenna system is disposed inside a vehicle roof to perform communication with nearby electronic devices, vehicles, and infrastructures.

### Mode for the Invention

Hereinafter, preferred embodiments of the present disclosure will be described in detail with reference to the accompanying drawings, and the same or similar elements are designated with the same numeral references regardless of the numerals in the drawings and redundant description thereof will be omitted. In general, a suffix such as "module" and "unit" may be used to refer to elements or components. Use of such a suffix herein is merely intended to facilitate description of the specification, and the suffix itself is not intended to give any special meaning or function. In describing the present disclosure, if a detailed explanation for a related known function or construction is considered to unnecessarily divert the gist of the present disclosure, such explanation has been omitted but would be understood by those skilled in the art. The accompanying drawings are used to help easily understand the technical idea of the present disclosure and it should be understood that the idea of the present disclosure is not limited by the accompanying drawings. The idea of the present disclosure should be construed to extend to any alterations, equivalents and substitutes besides the accompanying drawings.

It will be understood that although the terms first, second, etc. may be used herein to describe various elements, these elements should not be limited by these terms. These terms are generally only used to distinguish one element from another.

It will be understood that when an element is referred to as being "connected with" another element, the element can be connected with the another element or intervening elements may also be present. In contrast, when an element is referred to as being "directly connected with" another element, there are no intervening elements present.

A singular representation may include a plural representation unless it represents a definitely different meaning from the context.

Terms such as "include" or "has" are used herein and should be understood that they are intended to indicate an existence of several components, functions or steps, disclosed in the specification, and it is also understood that greater or fewer elements, functions, or steps may likewise be utilized.

An antenna system described herein may be mounted on a vehicle. Configurations and operations according to implementations may also be applied to a communication system, namely, antenna system mounted on a vehicle. In this regard, the antenna system mounted in the vehicle may include a plurality of antennas, and a transceiver circuit and a processor that control the plurality of antennas.

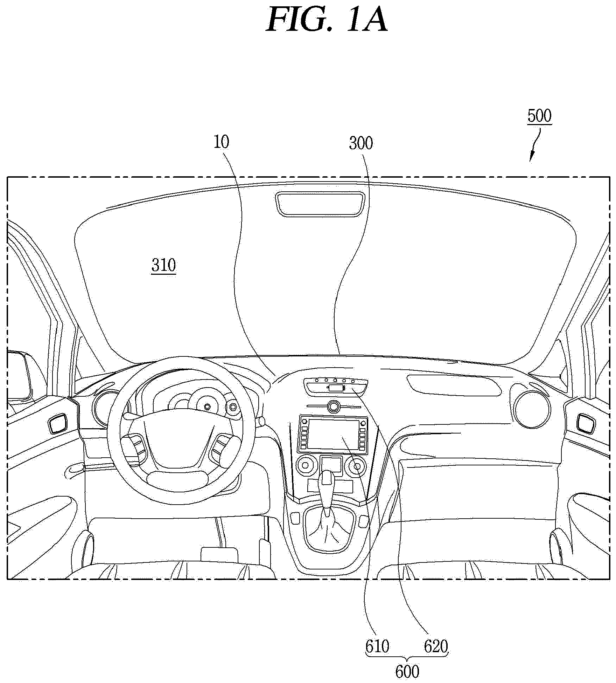

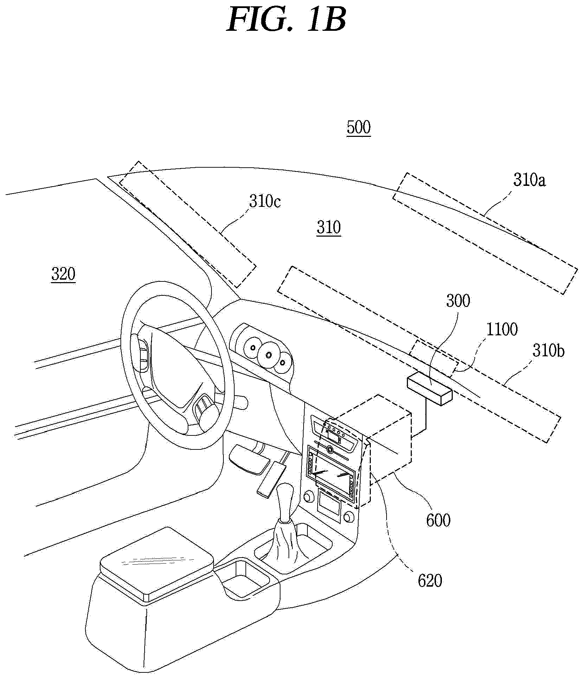

FIG. 1A is a diagram illustrating an internal configuration of a vehicle in accordance with one example. FIG. 1B is a lateral view illustrating the vehicle interior in accordance with the one example.

As illustrated in FIGS. 1A and 1B, the present disclosure describes an antenna unit (i.e., an internal antenna system) 1000 capable of transmitting and receiving signals through GPS, 4G wireless communication, 5G wireless communication, Bluetooth, or wireless LAN. Therefore, the antenna unit (i.e., the antenna system) 1000 capable of supporting these various communication protocols may be referred to as an integrated antenna module 1000. The antenna system 1000 may include a telematics control unit (TCU) 300 and an antenna assembly 1100. For example, the antenna assembly 1100 may be disposed on a window of a vehicle.

The present disclosure also describes a vehicle 500 having the antenna system 1000. The vehicle 500 may include a dashboard and a housing 10 including the telematics control unit (TCU) 300, and the like. In addition, the vehicle 500 may include a mounting bracket for mounting the telematics control unit (TCU) 300.

The vehicle 500 may include the telematics control unit (TCU) 300 and an infotainment unit 600 configured to be connected to the telematics control unit 300. A portion of a front pattern of the infotainment unit 600 may be implemented in the form of a dashboard of the vehicle. A display 610 and an audio unit 620 may be included in the dashboard of the vehicle.

The antenna assembly 1100, namely, the antenna module 1100 in the form of a transparent antenna may be disposed in at least one of an upper region 310a, a lower region 310b, and a side region 310c of a front window 310. The antenna assembly 1100 may also be disposed at a side window 320, which is disposed at a side surface of the vehicle, in addition to the front window 310.

As illustrated in FIG. 1B, when the antenna assembly 1100 is disposed at the lower region 310b of the front window 310, it may be operably coupled to a TCU 300 disposed inside the vehicle. When the antenna assembly 1100 is disposed at the upper region 310a or the side region 310c of the front window 310, it may be operably coupled to a TCU disposed outside the vehicle. However, the present disclosure may not be limited to the TCU coupling configuration inside or outside the vehicle.

### <V2X (Vehicle-to-Everything)>

V2X communication may include communications between a vehicle and all entities, such as V2V (Vehicle-to-Vehicle) which refers to communication between vehicles, V2I (Vehicle-to-Infrastructure) which refers to communication between a vehicle and an eNB or RSU (Road Side Unit), V2P (Vehicle-to-Pedestrian) which refers to communication between a vehicle and a terminal possessed by a person (pedestrian, cyclist, vehicle driver, or passenger), V2N (vehicle-to-network), and the like.

V2X communication may have the same meaning as V2X sidelink or NR V2X or may have, in a broader sense, a meaning including V2X sidelink or NR V2X.

V2X communication may be applicable to various services, for example, forward collision warning, an automatic parking assist system, cooperative adaptive cruise control (CACC), control-loss warning, traffic queuing warning, safety warning, traffic vulnerable-area safety warning, emergency vehicle warning, curved-road driving speed warning, and traffic flow control.

V2X communication may be provided through a PC5 interface and/or a Uu interface. In this case, specific network entities for supporting communications between a vehicle and all entities may exist in a wireless communication system supporting V2X communication. For example, the network entity may include a base station (eNB), a Road Side Unit (RSU), a terminal, or an application server (e.g., a traffic safety server).

In addition, a terminal performing V2X communication may refer to not only a general handheld UE but also a vehicle (V-UE), a pedestrian UE, an RSU of an eNB type, an RSU of a UE type, a robot equipped with a communication module, and the like.

V2X communication may be performed directly between terminals or may be performed through the network entity (entities). V2X operation modes may be classified according to a method of performing such V2X communication.

### Terms used in V2X communication may be defined as follows.

A Road Side Unit (RSU) is a V2X service enabled device that can transmit and receive data to and from a moving vehicle using V2I service. The RSU also serves as a stationary infrastructure entity that supports V2X application programs, and may exchange messages with other entities that support V2X application programs. The RSU is a term frequently used in existing ITS specifications, and the reason for employing the term RSU in association with the 3GPP specifications is to read relevant documents in an easier manner in the ITS industry. The RSU is a logical entity that combines a V2X application logic with the functionality of an eNB (referred to as an eNB-type RSU) or a UE (referred to as a UE-type RSU).

V2I Service is a type of V2X service, where one party is a vehicle whereas the other party is an entity belonging to infrastructure. A V2P Service is a type of V2X service, where one party is a vehicle whereas the other party is an entity belonging to an infrastructure. A V2X Service is a type of 3GPP communication service that involves a transmitting or receiving device on a vehicle. The V2X service may further be divided into a V2V service, a V2I service, and a V2P service according to which partner is involved in communication for the V2X service.

V2X enabled UE is a UE that supports V2X service. The V2V Service is a type of V2X service, where both parties involved in communication are vehicles. V2V communication range is a direct communication range between two vehicles involved in the V2V service.

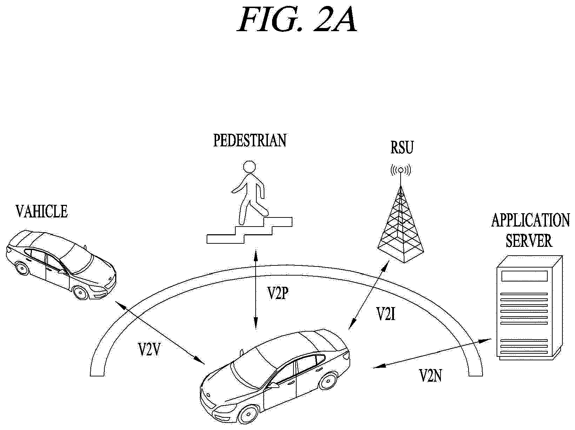

Four types of V2X applications called Vehicle-to-Everything (V2X), as described above, include (1) vehicle-to-vehicle (V2V), (2) vehicle-to-infrastructure (V2I), (3) vehicle-to-network (V2N), (4) vehicle-to-pedestrian (V2P). FIG. 2A illustrates types of V2X applications. Referring to FIG. 2A, the four types of V2X applications may use "cooperative awareness" to provide more intelligent services for end-users.

This means that, in order to provide more intelligent information, such as cooperative collision warning or autonomous traveling, entities, such as vehicles, roadside-based facilities, application servers and pedestrians, may collect knowledge of involved local environments (e.g., information received from nearby vehicles or sensor equipment) to process and share the corresponding knowledge.

### <NR V2X>

Support for V2V and V2X services has been introduced in LTE during Releases 14 and 15, in order to expand the 3GPP platform to the automotive industry.

Requirements for support of enhanced V2X use cases are largely organized into four use case groups.
(1) Vehicles Platooning enables the vehicles to dynamically form a platoon traveling together. All the vehicles in the platoon obtain information from the leading vehicle to manage this platoon. This information allows the vehicles to drive closer than normal in a coordinated manner, going to the same direction and traveling together.
(2) Extended Sensors enable the exchange of raw or processed data gathered through local sensors or live video images among vehicles, road site units, devices of pedestrians and V2X application servers. The vehicle can recognize an environment much more than through detection by its sensor and can recognize a local situation as a whole in a more extensive manner. A high data transmission rate is one of primarily features of the extended sensor.
(3) Advanced Driving enables semi-automated or full-automated driving. The advanced driving enables each vehicle and/or each RSU to share self-recognition data obtained from a local sensor with a nearby vehicle and to synchronize and adjust a trajectory or a maneuver. Each vehicle shares its intention to drive with a nearby vehicle.
(4) Remote driving serves to enable a remote driver or a V2X application program to drive a remotely-located vehicle in a dangerous environment by him/herself or itself or instead of an occupant who cannot drive the remotely-located vehicle. In a case where a traffic environment is limitedly changed and a vehicle driving path is predictable such as in public transportation, driving based on cloud computing may be available. High reliability and low latency are main requirements for the remote driving.

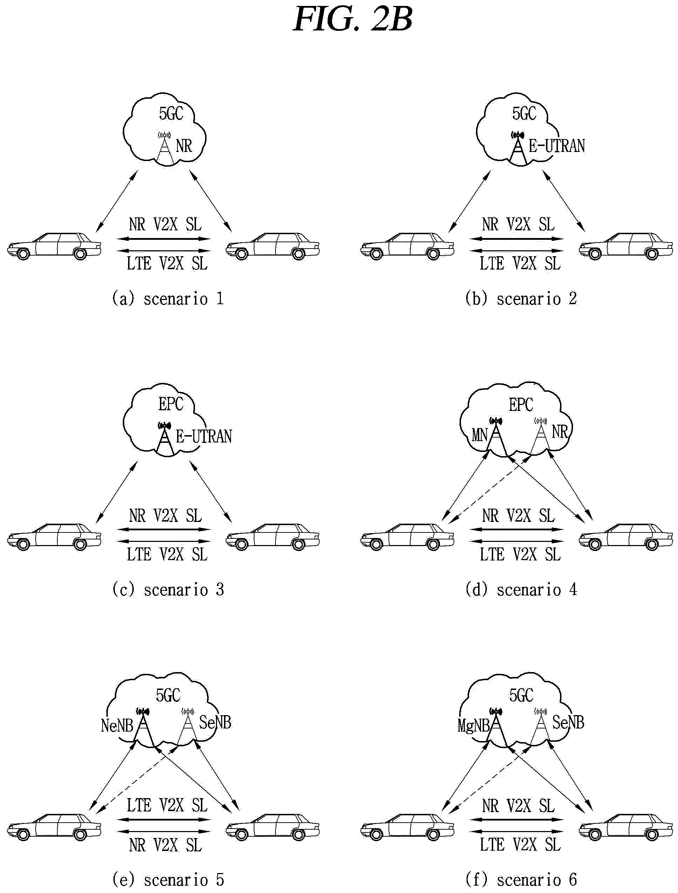

A description to be given below may be applicable to all of NR SL (sidelink) and LTE SL, and when no radio access technology (RAT) is indicated, the NR SL is meant. Six operational scenarios considered in NR V2X may be considered as follows. In this regard, FIG. 2B illustrates a standalone scenario supporting V2X SL communication and an MR-DC scenario supporting V2X SL communication.

In particular, 1) in Scenario 1, gNB provides control/configuration for UE's V2X communication in both LTE SL and NR SL. 2) In Scenario 2, ng-eNB provides control/configuration for UE's V2X communication in both LTE SL and NR SL. 3) In Scenario 3, eNB provides control/configuration for UE's V2X communication in both LTE SL and NR SL. On the other hand, 4) in Scenario 4, the UE's V2X communication in the LTE SL and the NR SL is controlled/configured by Uu while the UE is configured with EN-DC. 5) In Scenario 5, the UE's V2X communication in the LTE SL and the NR SL is controlled/configured by Uu while the UE is configured in NE-DC. 6) In Scenario 6, the UE's V2X communication in the LTE SL and the NR SL is controlled/configured by Uu while the UE is configured in NGEN-DC.

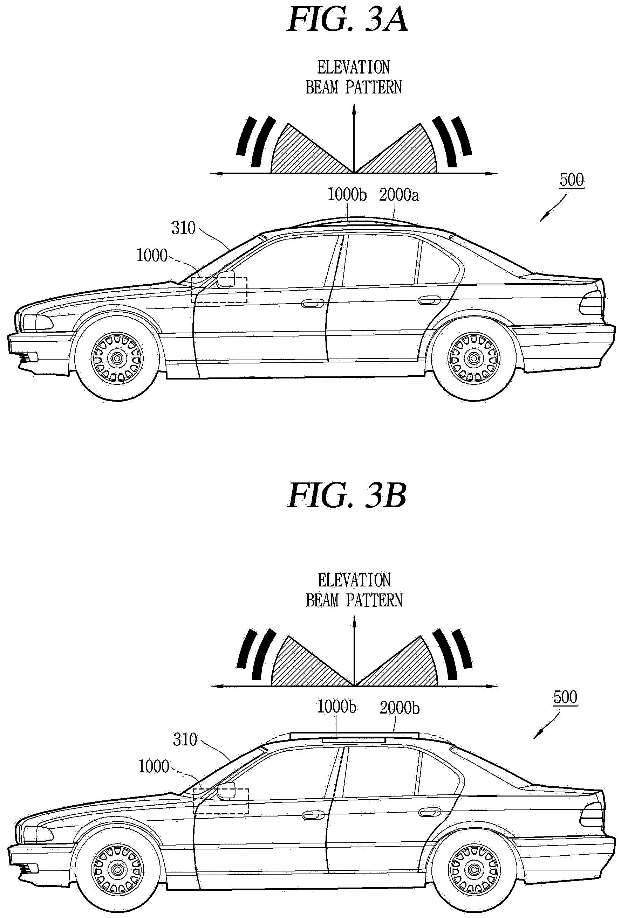

In order to support the V2X communication, as illustrated in FIGS. 2A and 2B, the vehicle may perform wireless communication with eNB and/or gNB through an antenna system. The antenna system may be configured as an internal antenna system as illustrated in FIGS. 1A and 1B. The antenna system may alternatively be implemented as an external antenna system and/or an internal antenna system as illustrated in FIGS. 3A to 3C.

FIGS. 3A to 3C are views illustrating an example of a structure for mounting an antenna system on a vehicle, which includes the antenna system mounted on the vehicle. In this regard, FIGS. 3A to 3C illustrate a configuration capable of performing wireless communication through a transparent antenna disposed on the front window 310 of the vehicle. An antenna system 1000 including a transparent antenna may be disposed on a front window of a vehicle and inside the vehicle. Wireless communication may also be performed through a transparent antenna disposed on a side glass of the vehicle, in addition to the front window.

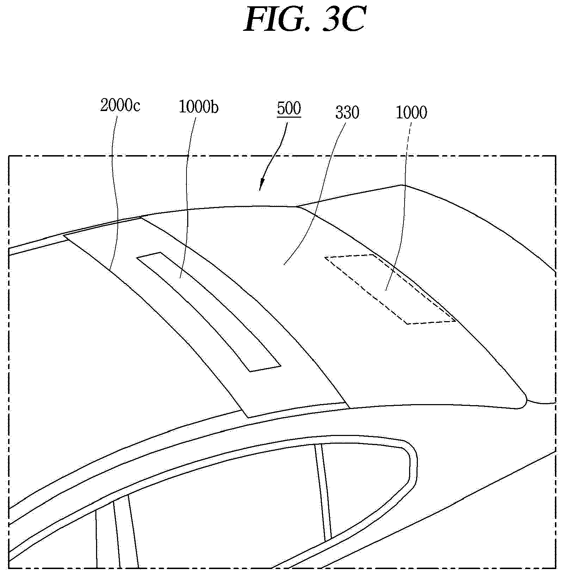

The antenna system for the vehicle that includes the transparent antenna can be combined with other antennas. Referring to FIGS. 3A to 3C, in addition to the antenna system 1000 implemented as the transparent antenna, a separate antenna system 1000b may be further configured. FIGS. 3A and 3B illustrate a structure in which the antenna system 1000b, in addition to the antenna system 1000, is mounted on or in a roof of the vehicle. On the other hand, FIG. 3C illustrates a structure in which the separate antenna system 1000b, in addition to the antenna system 1000, is mounted in a roof frame of a roof and a rear mirror of the vehicle.

Referring to FIGS. 3A to 3C, in order to improve the appearance of the vehicle and to maintain a telematics performance at the time of collision, an existing shark fin antenna may be replaced with a flat antenna of a non-protruding shape. In addition, the present disclosure proposes an integrated antenna of an LTE antenna and a 5G antenna considering fifth generation (5G) communication while providing the existing mobile communication service (e.g., LTE).

Referring to FIG. 3A, the antenna system 1000 implemented as the transparent antenna may be disposed on the front window 310 of the vehicle and inside the vehicle. The second antenna system 1000b corresponding to an external antenna may be disposed on the roof of the vehicle. In FIG. 3A, a radome 2000a may cover the second antenna system 1000b to protect the second antenna system 1000b from an external environment and external impacts while the vehicle travels. The radome 2000a may be made of a dielectric material through which radio signals are transmitted/received between the second antenna system 1000b and a base station.

Referring to FIG. 3B, the antenna system 1000 implemented as the transparent antenna may be disposed on the front window 310 of the vehicle and inside the vehicle. One the other hand, the second antenna system 1000b corresponding to the external antenna may be disposed within a roof structure of the vehicle and at least part of the roof structure 2000b may be made of a non-metallic material. At this time, the roof structure 2000b of the vehicle except for the at least part made of the non-metallic material may be made of a dielectric material through which radio signals are transmitted/received between the antenna system 1000b and the base station.

Referring to FIG. 3C, the antenna system 1000 implemented as the transparent antenna may be disposed on the rear window 330 of the vehicle and inside the vehicle. The second antenna system 1000b corresponding to the external antenna may be disposed within the roof frame 2000c of the vehicle, and at least part of the roof frame may be made of a non-metallic material. At this time, the roof frame 2000c of the vehicle 500 except for the at least part made of the non-metallic material may be made of a dielectric material through which radio signals are transmitted/received between the second antenna system 1000b and the base station.

Referring to FIGS. 3A to 3C, antennas provided in the antenna system 1000 mounted on the vehicle may form a beam pattern in a direction perpendicular to the front window 310 or the rear window 330. Antenna provided in the second antenna system 1000 mounted on the vehicle may further define a beam coverage by a predetermined angle in a horizontal region with respect to the vehicle body.

Meanwhile, the vehicle 500 may include only the antenna unit (i.e., the internal antenna system) 1000 corresponding to the internal antenna without the antenna system 1000b corresponding to the external antenna.

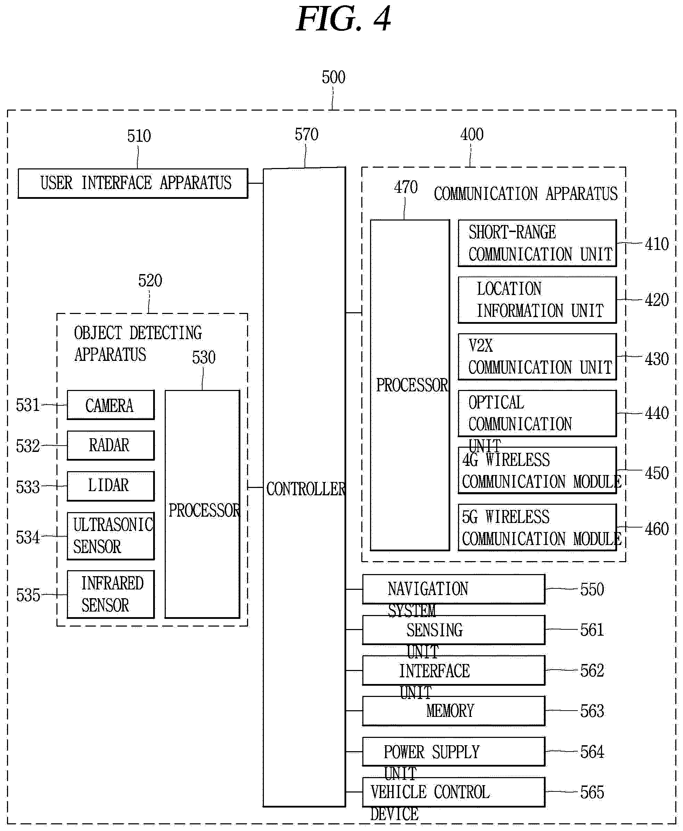

Meanwhile, FIG. 4 is a block diagram illustrating a vehicle and an antenna system mounted on the vehicle in accordance with an implementation.

The vehicle 500 may be an autonomous (driving) vehicle. The vehicle 500 may be switched into an autonomous driving mode or a manual mode (a pseudo driving mode) based on a user input. For example, the vehicle 500 may be switched from the manual mode into the autonomous mode or from the autonomous mode into the manual mode based on a user input received through a user interface apparatus 510.

In relation to the manual mode and the autonomous driving mode, operations such as object detection, wireless communication, navigation, and operations of vehicle sensors and interfaces may be performed by the telematics control unit mounted on the vehicle 500. Specifically, the telematics control unit mounted on the vehicle 500 may perform the operations in cooperation with the antenna module 300, the object detecting apparatus 520, and other interfaces. In some examples, the communication apparatus 400 may be disposed in the telematics control unit separately from the antenna system 300 or may be disposed in the antenna system 300.

The vehicle 500 may be switched into the autonomous mode or the manual mode based on driving environment information. The driving environment information may be generated based on object information provided by the object detecting apparatus 520. For example, the vehicle 500 may be switched from the manual mode into the autonomous driving mode or from the autonomous driving mode into the manual mode based on driving environment information generated in the object detecting apparatus 520.

For example, the vehicle 500 may be switched from the manual mode into the autonomous driving mode or from the autonomous driving mode into the manual mode based on driving environment information received through the communication apparatus 400. The vehicle 500 may be switched from the manual mode into the autonomous driving mode or from the autonomous driving mode into the manual mode based on information, data or signal provided by an external device.

When the vehicle 500 travels in the autonomous mode, the autonomous vehicle 500 may travel under the control of an operation system. For example, the autonomous vehicle 500 may travel based on information, data or signal generated in a driving system, a parking exit (parking-lot leaving) system, and a parking system. When the vehicle 500 is driven in the manual mode, the autonomous vehicle 500 may receive a user input for driving through a driving control apparatus. The vehicle 500 may travel based on the user input received through the driving control apparatus.

The vehicle 500 may include a user interface apparatus 510, an object detecting apparatus 520, a navigation system 550, and a communication apparatus 400. The vehicle may further include a sensing unit 561, an interface unit 562, a memory 563, a power supply unit 564, and a vehicle control device 565 in addition to the aforementioned apparatuses and devices. In some implementations, the vehicle 500 may include more components in addition to components to be explained herein or may not include some of those components to be explained herein.

The user interface apparatus 510 may be an apparatus for communication between the vehicle 500 and a user. The user interface apparatus 510 may receive a user input and provide information generated in the vehicle 500 to the user. The vehicle 500 may implement user interfaces (Uls) or user experiences (UXs) through the user interface apparatus 510.

The object detecting apparatus 520 may be a device for detecting an object located at outside of the vehicle 500. The object may be a variety of things associated with driving (operation) of the vehicle 500. In some examples, objects may be classified into moving objects and fixed (stationary) objects. For example, the moving objects may include other vehicles and pedestrians. The fixed objects may conceptually include traffic signals, roads, and structures, for example. The object detecting apparatus 520 may include a camera 521, a radar 522, a LiDAR 523, an ultrasonic sensor 524, an infrared sensor 525, and a processor 530. In some implementations, the object detecting apparatus 520 may further include other components in addition to the components described, or may not include some of the components described.

The processor 530 may control an overall operation of each unit of the object detecting apparatus 520. The processor 530 may detect an object based on an acquired image, and track the object. The processor 530 may execute operations, such as computing of a distance to the object, computing of a relative speed with respect to the object and the like, through an image processing algorithm.

According to an embodiment, the object detecting apparatus 520 may include a plurality of processors 530 or may not include any processor 530. For example, each of the camera 521, the radar 522, the LiDAR 523, the ultrasonic sensor 524 and the infrared sensor 525 may include the processor in an individual manner.

When the processor 530 is not included in the object detecting apparatus 520, the object detecting apparatus 520 may operate according to the control of a processor of an apparatus within the vehicle 500 or the controller 570.

The navigation system 550 may provide location information related to the vehicle based on information obtained through the communication apparatus 400, in particular, a location information unit 420. Also, the navigation system 550 may provide a path (or route) guidance service to a destination based on current location information related to the vehicle. In addition, the navigation system 550 may provide guidance information related to surroundings of the vehicle based on information obtained through the object detecting apparatus 520 and/or a V2X communication unit 430. In some examples, guidance information, autonomous driving service, etc. may be provided based on V2V, V2I, and V2X information obtained through a wireless communication unit operating together with the antenna system 1000.

The communication apparatus 400 may be an apparatus for performing communication with an external device. Here, the external device may be another vehicle, a mobile terminal, or a server. The communication apparatus 400 may perform the communication by including at least one of a transmitting antenna, a receiving antenna, and radio frequency (RF) circuit and RF device for implementing various communication protocols. The communication apparatus 400 may include a short-range communication unit 410, a location information unit 420, a V2X communication unit 430, an optical communication unit 440, a 4G wireless communication module 450, and a processor 470. According to an embodiment, the communication apparatus 400 may further include other components in addition to the components described, or may not include some of the components described.

The short-range communication unit 410 is a unit for facilitating short-range communications. The short-range communication unit 410 may construct short-range wireless area networks to perform short-range communication between the vehicle 500 and at least one external device. The location information unit 420 may be a unit for acquiring location information related to the vehicle 500. For example, the location information unit 420 may include a Global Positioning System (GPS) module or a Differential Global Positioning System (DGPS) module.

The V2X communication unit 430 may be a unit for performing wireless communication with a server (Vehicle to Infrastructure; V2I), another vehicle (Vehicle to Vehicle; V2V), or a pedestrian (Vehicle to Pedestrian; V2P). The V2X communication unit 430 may include an RF circuit in which protocols for communication with an infrastructure (V2I), communication between vehicles (V2V), and communication with a pedestrian (V2P) are executable. The optical communication unit 440 may be a unit for performing communication with an external device through the medium of light. The optical communication unit 440 may include an optical transmission part for converting an electric signal into an optical signal and transmitting the optical signal to the outside, and an optical reception part for converting the received optical signal into the electric signal. According to an embodiment, the optical transmission part may be formed integrally with lamps provided on the vehicle 500.

The wireless communication unit 460 is a unit that performs wireless communication with one or more communication systems through one or more antenna systems. The wireless communication unit 460 may transmit and/or receive a signal to and/or from a device in a first communication system through a first antenna system. In addition, the wireless communication unit may transmit and/or receive a signal to and/or from a device in a second communication system through a second antenna system. For example, the first communication system and the second communication system may be an LTE communication system and a 5G communication system, respectively. However, the first communication system and the second communication system may not be limited thereto, and may be changed according to applications.

In some examples, the antenna module 300 disposed in the vehicle 500 may include a wireless communication unit. In this regard, the vehicle 500 may be an electric vehicle (EV) or a vehicle that can be connected to a communication system independently of an external electronic device. In this regard, the communication apparatus 400 may include at least one of the short-range communication unit 410, the location information unit 420, the V2X communication unit 430, the optical communication unit 440, a 4G wireless communication module 450, and a 5G wireless communication module 460.

The 4G wireless communication module 450 may perform transmission and reception of 4G signals with a 4G base station through a 4G mobile communication network. In this case, the 4G wireless communication module 450 may transmit at least one 4G transmission signal to the 4G base station. In addition, the 4G wireless communication module 450 may receive at least one 4G reception signal from the 4G base station. In this regard, uplink (UL) multi-input multi-output (MIMO) may be performed by a plurality of 4G transmission signals transmitted to the 4G base station. In addition, downlink (DL) MIMO may be performed by a plurality of 4G reception signals received from the 4G base station.

The 5G wireless communication module 460 may perform transmission and reception of 5G signals with a 5G base station through a 5G mobile communication network. Here, the 4G base station and the 5G base station may have a Non-Stand-Alone (NSA) architecture. For instance, the 4G base station and the 5G base station may have a Non-Stand-Alone (NSA) architecture. Alternatively, the 5G base station may be disposed in a Stand-Alone (SA) structure at a separate location from the 4G base station. The 5G wireless communication module 460 may perform transmission and reception of 5G signals with a 5G base station through a 5G mobile communication network. In this case, the 5G wireless communication module 460 may transmit at least one 5G transmission signal to the 5G base station. In addition, the 5G wireless communication module 460 may receive at least one 5G reception signal from the 5G base station. In this instance, 5G and 4G networks may use the same frequency band, and this may be referred to as LTE re-farming. In some examples, a sub-6 frequency band, which is a range of 6 GHz or less, may be used as the 5G frequency band. On the other hand, a millimeter-wave (mmWave) range may be used as the 5G frequency band to perform wideband high-speed communication. When the mmWave band is used, the electronic device may perform beamforming for coverage expansion of an area where communication with a base station is possible.

On the other hand, regardless of the 5G frequency band, 5G communication systems can support a larger number of multi-input multi-output (MIMO) to improve a transmission rate. In this instance, UL MIMO may be performed by a plurality of 5G transmission signals transmitted to a 5G base station. In addition, DL MIMO may be performed by a plurality of 5G reception signals received from the 5G base station.

In some examples, the wireless communication unit 110 may be in a Dual Connectivity (DC) state with the 4G base station and the 5G base station through the 4G wireless communication module 450 and the 5G wireless communication module 460. As such, the dual connectivity to the 4G base station and the 5G base station may be referred to as EUTRAN NR DC (EN-DC). When the 4G base station and 5G base station are disposed in a co-located structure, throughput improvement may be achieved by inter-Carrier Aggregation (inter-CA). Therefore, when the 4G base station and the 5G base station are disposed in the EN-DC state, the 4G reception signal and the 5G reception signal may be simultaneously received through the 4G wireless communication module 450 and the 5G wireless communication module 460, respectively. Short-range communication between electronic devices (e.g., vehicles) may be performed using the 4G wireless communication module 450 and the 5G wireless communication module 460. In one embodiment, after resources are allocated, vehicles may perform wireless communication in a V2V manner without a base station.

Meanwhile, for transmission speed improvement and communication system convergence, carrier aggregation (CA) using at least one of the 4G wireless communication module 450 and 5G wireless communication module 460 and the Wi-Fi communication module 113. In this regard, 4G + WiFi carrier aggregation (CA) may be performed using the 4G wireless communication module 450 and the Wi-Fi communication module 113. Or, 5G + WiFi CA may be performed using the 5G wireless communication module 460 and the Wi-Fi communication module.

In some examples, the communication apparatus 400 may implement a display apparatus for a vehicle together with the user interface apparatus 510. In this instance, the display apparatus for the vehicle may be referred to as a telematics apparatus or an Audio Video Navigation (AVN) apparatus.

The processor 470 of the communication apparatus 400 may correspond to a modem. In this regard, the RFIC and the modem may be referred to as a first controller (or a first processor) and a second controller (a second processor), respectively. Meanwhile, the RFIC and the modem may be implemented as physically separate circuits. Alternatively, the RFIC and the modem may be logically or functionally distinguished from each other on one physical circuit. The modem may perform control and signal processing for the transmission and reception of signals through different communication systems through the RFIC. The modem 1400 may acquire control information from a 4G base station and/or a 5G base station. Here, the control information may be received through a physical downlink control channel (PDCCH), but the present disclosure is not limited thereto.

The modem may control the RFIC 1250 to transmit and/or receive signals through the first communication system and/or the second communication system for a specific time interval and from frequency resources. Accordingly, the vehicle can be allocated resources or maintain a connected state through the eNB or gNB. In addition, the vehicle may perform at least one of V2V communication, V2I communication, and V2P communication with other entities using the allocated resources.

Meanwhile, referring to FIGS. 1A to 4, the antenna module mounted on the vehicle may be disposed inside the vehicle, on the roof of the vehicle, inside the roof, or inside the roof frame. In this regard, the antenna system disclosed herein may be configured to operate in a low band (LB), mid band (MB), and high band (HB) of a 4G LTE system and a sub-6 band of a 5G NR system. In addition, the antenna system disclosed herein may be configured to operate in a 2.4 GHz band, a 5.5 GHz band, and a 6.5 GHz band to provide Wi-Fi 6 and Wi-Fi 7 communication services.

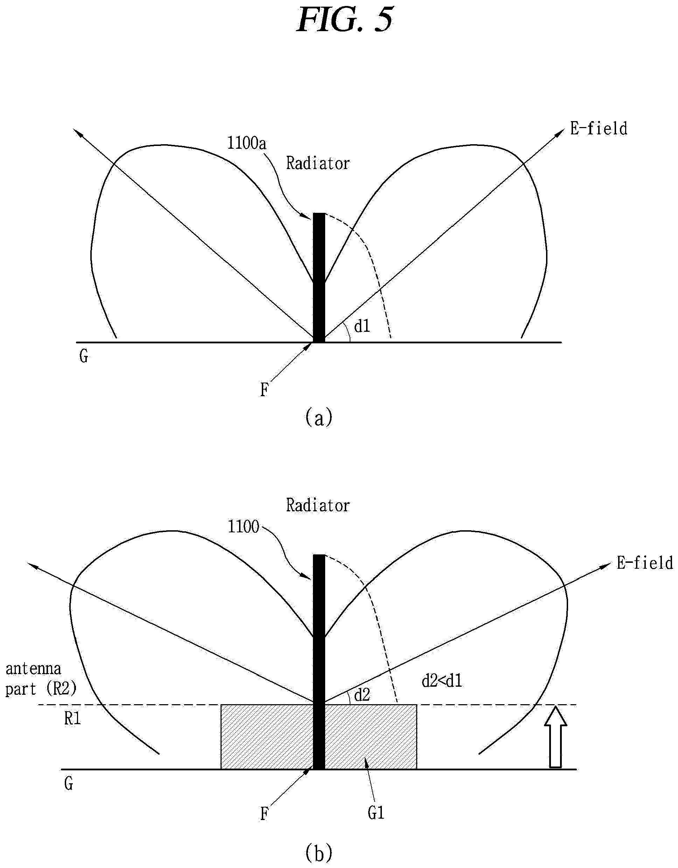

In this regard, FIG. 5 shows diagrams in which radiation patterns depending on whether a ground is disposed on a rear side of an antenna element are compared when the antenna element is disposed perpendicular to a horizontal plane. (a) of FIG. 5 shows a structure in which no ground is disposed on a rear side of the antenna element and a resultant radiation pattern. (b) of FIG. 5 shows a structure in which a ground is disposed on a rear side of the antenna element and a resultant radiation pattern.

Regarding the structures of (a) and (b) of FIG. 5, the ground G may be a ground disposed in a metal structure inside a roof 2000a to 2000c of the vehicle of FIGS. 3A to 3C. Referring to (a) of FIG. 5, an antenna element 1100a may be disposed between a roof 2000a to 2000c of the vehicle and a ground inside the roof. Accordingly, a radiation pattern by the antenna element 1100a is formed in a sky direction with respect to a horizontal plane. That is, a beam peak of the radiation pattern by the antenna element 1100a may be formed at an angle d1 with respect to the horizontal plane.

Referring to (b) of FIG. 5, a beam peak of the radiation pattern by the antenna element 1100 may be formed at an angle d2 with respect to the horizontal plane. The beam peak angle d2 by the antenna element 1100 in (b) of FIG. 5 is formed at an angle smaller than the beam peak angle d1 by the antenna element 1100a in (a) of FIG. 5.

In this regard, a ground G1 is disposed on a rear portion of the antenna element 1100. Therefore, a first region R1 consisting of the antenna pattern and the ground G1 disposed in a lower region of the antenna element 1100 constitutes a transmission line. Accordingly, an antenna part that substantially operates as a radiator is disposed in a second region R2, which is an upper region of the first region R1 constituting the transmission line. Therefore, a point where the ground in (b) of FIG. 5 is disposed is located higher than a point where the ground in (a) of FIG. 5 is disposed. Accordingly, the radiation pattern of the antenna element 1100 in (b) of FIG. 5 has a lower elevation radiation characteristic than the antenna element 1100a in (a) of FIG. 5.

Therefore, the antenna pattern corresponding to the radiator disposed in the antenna part is disposed in the second region R2, which is an upper region than a power feeder F disposed in the first region R1. Meanwhile, the ground G1 disposed on the rear portion of the antenna element 1100 may be connected to the ground G of the PCB 1200 disposed on a horizontal plane. In this regard, a width of a ground pattern constituting the ground G1 may be implemented to be above about twice or above three times a width of a conductive pattern on a front side on which the antenna element 1100 is disposed. The ground G1 may be frequency-selectively connected to the ground G of the PCB 1200 through a filter.

As described above, as the height of a point where the ground is disposed increases as shown in (b) of FIG. 5, a radiation pattern of the antenna element 1100 in (b) of FIG. 5 has a lower elevation radiation characteristic than that of the antenna element 1100a in (a) of FIG. 5. Meanwhile, a vehicle antenna module in which the antenna element 1100a, 1100 in (a) and (b) of FIG. 5 is disposed may perform a vehicle communication and control function, and may be referred to as a vehicle telemetric control unit (TCU). In this regard, it may be configured to connect the vehicle TCU and a separate shark fin antenna with a coaxial cable, but due to an increase in number of antennas and an increase in design requirements, but this specification proposes a structure in which antenna elements are disposed within a module.

A vehicle antenna requires a low elevation radiation pattern. However, due to a location where the antenna is mounted on the vehicle and a structure of the TCU, there is a problem in that the radiation pattern is formed at a relatively high angle with respect to a horizontal plane, so that the beam peak to be directed toward the sky. Therefore, in order to implement a low elevation radiation characteristic of a vehicle antenna, a height of the antenna must be structurally increased. Meanwhile, this specification proposes a structure of a wideband antenna element capable of implementing a low elevation radiation characteristic while implementing a low profile structure that maintains an overall height of the antenna below a predetermined height.

Hereinafter, a wideband antenna provided in an antenna module that can be disposed in a vehicle according to this specification will be described. Meanwhile, the antenna presented herein may be implemented as a vehicle WiFi antenna to provide a WiFi communication service in a vehicle. In relation to the WiFi communication service, the vehicle WiFi antenna may operate in a 5 GHz band and a 6 GHz band in addition to a 2.4 GHz band to provide Wi-Fi 6 and Wi-Fi 7 communication services.

Wi-Fi 6 (IEEE 802.11 ax; hereinafter referred to as 802.11 ax) is a Wi-Fi standard designed by IEEE with a goal of providing the best Internet quality even in a public Wi-Fi environment through optimizing multiple access environments. Wi-Fi 6 may support speeds of up to 10Gbps and achieve speeds of 1Gbps with wider coverage and lower latency. Therefore, Wi-Fi 6 is also called high-efficiency wireless (HEW) by IEEE and the Wi-Fi Alliance. Meanwhile, Wi-Fi 6E, which is an extension standard of Wi-Fi 6, defines communication at 6 GHz, an unlicensed frequency, as the standard.

Wi-Fi 6 introduces new technologies such as OFDMA, improved MU-MIMO that can be used in both downlink and uplink, spatial frequency reuse, target wake time (TWT), and dynamic fragmentation. Support for up to 256-QAM in 802.11ac has been extended to 1024-QAM. The 802.11ac standard only supports a 5 GHz band, but Wi-Fi 6 may use 2.4 GHz in addition to 5 GHz.

Wi-Fi 7 is a next-generation Wi-Fi standard based on the IEEE 802.11be standard currently being studied by IEEE. Wi-Fi 7 is also called extremely high throughput (EHT). IEEE aims to achieve speeds of up to 30 Gbps in Wi-Fi 7. This is the same goal sought to be implemented in 5G mobile communication.

Wi-Fi 6 introduces technologies focused on maximizing efficiency in a multi-access environment. Meanwhile, Wi-Fi 7 aims to implement low latency (low delay time) and wide transmission speeds to prepare for the era of the 4th industrial revolution, like new radio (NR), which is the 5th generation mobile communication technology.

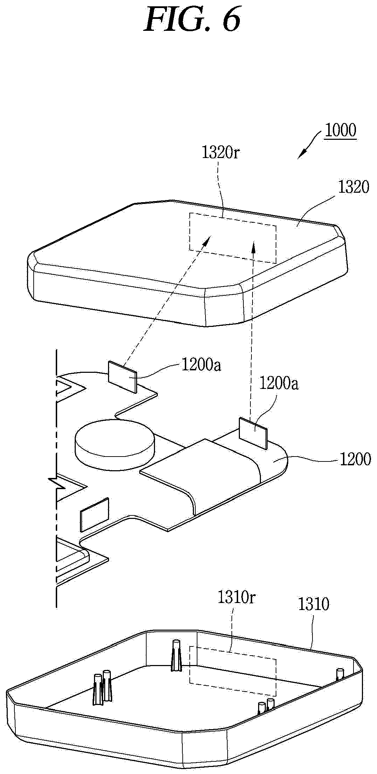

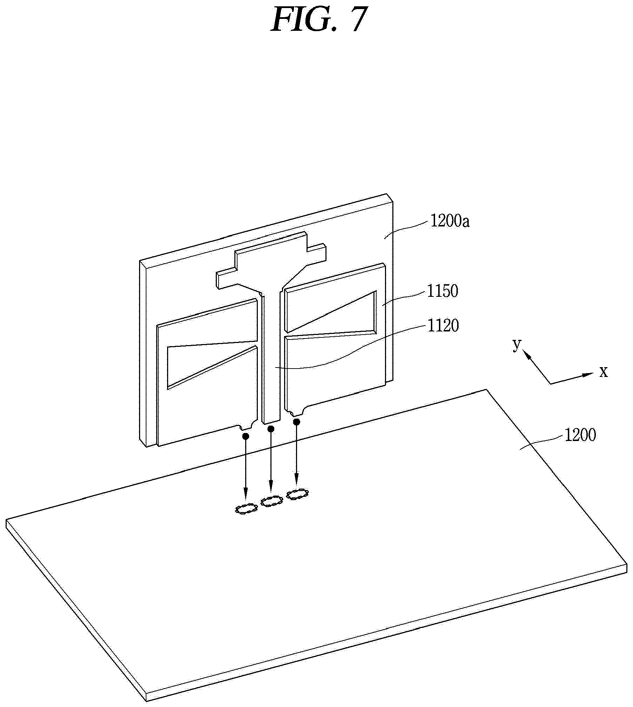

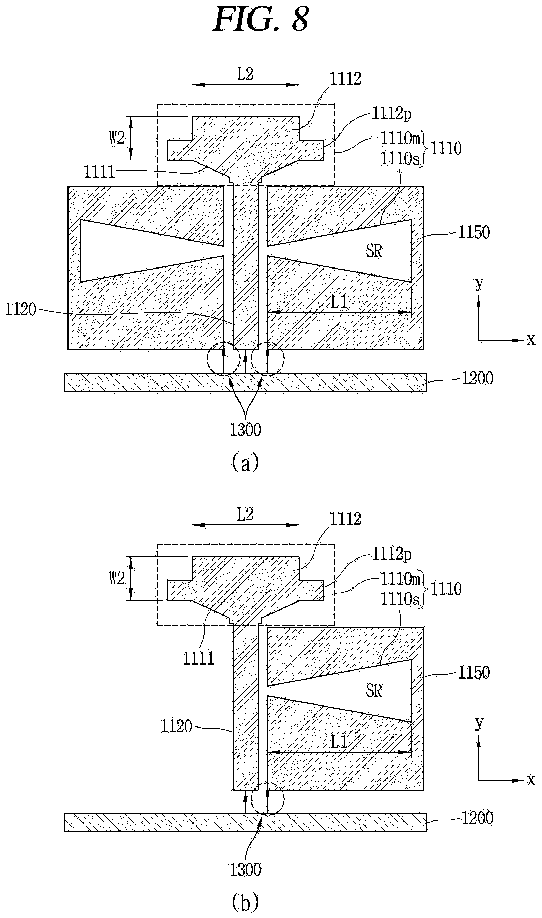

In order to provide such Wi-Fi 6 and Wi-Fi 7 communication services in a vehicle, an antenna structure having a wideband characteristic and a low elevation beam pattern according to this specification is presented. In this regard, FIG. 6 shows an exploded view of an antenna module having a wideband antenna according to this specification. In order to provide such Wi-Fi 6 and Wi-Fi 7 communication services in a vehicle, FIG. 7 shows a configuration in which an antenna PCB disposed with the wideband antenna of FIG. 6 is coupled to a PCB. Meanwhile, FIG. 8 shows structures of wideband antennas according to different embodiments.

Referring to FIGS. 6 to 8, an antenna module 1000 mounted on a vehicle according to this specification may include a PCB 1200 and an antenna PCB 1200a. The antenna module may include a PCB 1200, an antenna PCB 1200a, and a filter part 1300.

A wideband antenna element disposed in the antenna module according to this specification operates as an antenna having 2.4 GHz, 5.5 GHz, and 6.5 GHz operation modes through a bow-tie slot structure. A ground pattern of the antenna element may be connected to a ground of the PCB 1200 through a filter.

Meanwhile, the wideband antenna element presented herein is open to the ground of the PCB at 2.5 GHz, which corresponds to a first band, to operate as an antenna as a whole along with the grounds on both sides. The wideband antenna element is shorted thereto from a second band to constitute a CPW transmission line.

There are two modes in a 5 GHz band. Since the grounds on both sides becomes a transmission line, an upper antenna pattern forms a single antenna mode to operate as a monopole antenna. Meanwhile, the wideband antenna element operates in a slot mode, which is another mode, through a bow-tie shaped slot 1110s on the ground pattern corresponding to a middle region. There are two modes in 5.5 GHz and 6.5 GHz bands (second and third bands), and the antenna element may operate in a slightly more dominant mode depending on each frequency. Two modes are shown in an overlapping manner in a middle band between the second and third bands, and as approaching 5.5 GHz and 6.5 GHz, which are the second and third bands, one mode becomes dominant to operate closer to one mode.

Referring to FIG. 6, the antenna module 1000 may include a PCB 1200, a bottom cover 1310, a top cover 1320, and an antenna PCB 1200a. A printed circuit board (PCB) 1200 may be configured to form a transmission line through which a wireless signal is transmitted. The bottom cover 1310 may be configured such that the PCB 1200 is disposed thereon. The top cover 1320 may be fastened to the bottom cover 1310 to accommodate the PCB 1200 therein.

The antenna PCB 1200a may be operably coupled to the PCB 1200. A wireless signal transmitted through a transmission line of the PCB 1200 may be transmitted to the antenna PCB 1200a.

Referring to FIGS. 6 to 8, the antenna PCB 1200a may be formed of a dielectric substrate. The antenna PCB 1200a is configured to be coupled to the PCB 1200. The antenna PCB 1200a is configured to be coupled substantially in perpendicular to the PCB 1200. A feed pattern 1120 may be disposed on one surface of the antenna PCB 1200a and a metal pattern 1150 may be disposed on at least one of one side and the other side of the feed pattern 1120. The metal pattern 1150 may operate as a ground pattern. Accordingly, the feed pattern 1120 in (a) of FIG. 8 constitutes a symmetrical co-planar waveguide (CPW) transmission line with ground patterns disposed on both sides thereof. Meanwhile, the feed pattern 1120 in (b) of FIG. 8 constitutes an asymmetric CPW transmission line with a ground pattern disposed on one side.

Referring to (a) of FIG. 8, the metal pattern 1150 is disposed on both one side and the other side of the feed pattern 1120. Referring to (b) of FIG. 8, the metal pattern 1150 is disposed on only one side or the other side of the feed pattern 1120. Therefore, the antenna structure in (b) of FIG. 7 may reduce the overall antenna size compared to the antenna structure in (a) of FIG. 7. Therefore, the antenna structure in (a) of FIG. 7 may be referred to as an "original structure," and the antenna structure in (b) of FIG. 7 may be referred to as a "size reduction structure."

The antenna PCB 1200a may include a slot radiator 1110s and a second radiator 1110m. The second radiator 1110m may be referred to as a metal radiator since a metal region operates as a radiator. In addition, the second radiator 1110m has the shape of a patch radiator and may therefore be referred to as a patch radiator. The slot radiator 1110s may also be referred to as a first radiator. A radiator including the slot radiator 1110s and the second radiator 1110m may be referred to as an antenna element 1100.

The slot radiator 1110s is configured to radiate a wireless signal through a slot region disposed to have a first length L1 in a first axis direction inside the metal pattern 1150. The slot radiator 1110s is configured to radiate a wireless signal through a slot region disposed to have a first length L1 in an x-axis direction inside at least one of one side and the other side of the metal pattern 1150.

The slot radiator 1110s is disposed to have a first length L1 in a first axis direction with respect to the center point of the slot region SR, and configured to gradually increase in width in a second axis direction with respect to the center point. Therefore, the slot radiator 1110s may be configured as a slot radiator having a tapered shape. Meanwhile, the slot region SR may be configured to increase in width in the second axis direction up to a predetermined length in the first axis direction, and may be configured to have a constant width from the predetermined length to the first length L1.

The second radiator 1110m is configured to be connected to an end portion of the feed pattern 1120. The second radiator 1110m may be disposed in an upper region of the metal pattern 1150 in a second axis direction, that is, a y-axis direction. The second radiator 1110m may be implemented as a monopole radiator having a tapered shape. The slot radiator 1100s and the second radiator 1110m may constitute an antenna element 1110, that is, a radiator module 1110.

The second radiator 1110m may be disposed to have a plurality of metal regions. In this regard, the second radiator may include a first region 1111 and a second region 1112. The first region 1111 and the second region 1112 may be referred to as a first radiation region 1111 and a second radiation region 1112. The first region 1111 may be connected to an end portion of the feed pattern 1120, and configured to increase in width in the second axis direction. The second region 1112 may be connected to an end portion of the first region 1111 in the second axis direction. The second region 1112 may be disposed to have a second length L2 in the first axis direction and a second width W2 in the second axis direction. The second radiator 1110m may be configured to radiate a wireless signal in the first band.

The second region 1112 may be disposed in a structure whose length changes at one point thereof to optimize an impedance matching characteristic of the second radiator 1110m. In this regard, the second region 1112 has a parasitic metal pattern 1112p disposed such that a length of the second region 1112 extends from an end portion of the first region 1111 to one side and the other side in the first axis direction. The parasitic metal pattern 1112p may be disposed on one side and the other side of the second region 1112, and thus may be referred to as a parasitic wing structure.

A wideband antenna structure according to this specification is a structure in which a physical resonance position of the antenna is located higher by adding a transmission line to a lower part of the antenna. Accordingly, the low elevation radiation characteristic of the antenna may be improved. In addition, operations above 2.4 GHz and 5 GHz may be separated through the filter part 1300 to operate in multiple modes, thereby implementing an antenna having a wide bandwidth.

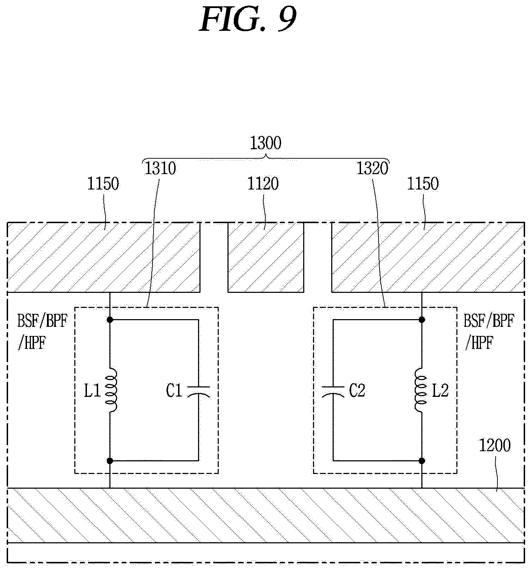

In this regard, the filter part 1300 may be configured to electrically connect or separate the metal pattern 1150 and the ground pattern of the PCB 1200 in a specific band. FIG. 9 shows an equivalent circuit when a filter part is disposed in the wideband antenna structure of FIG. 7.

Referring to FIGS. 7 to 9, in a 2.5 GHz band corresponding to the first band, the filter part 1300 is configured to have a separate structure in which the metal pattern 1150 and the ground pattern of the PCB 1200 are not connected to each other. The filter part 1300 is configured to block a signal in the first band such that the metal pattern 1150 and the ground pattern of the PCB 1200 are not connected to each other in the first band. Therefore, a signal in the first band applied through the feed pattern 1120 is radiated through the slot radiator 1110s and the second radiator 1110m. Therefore, the radiator module 1110 in the first band operates in a combined mode that combines a slot mode and a monopole mode.

In a 5 to 6 GHz band corresponding to the second band, the filter part 1300 configures the metal pattern 1150 and the ground pattern of the PCB 1200 to have a connected structure. The filter part 1300 is configured to pass a signal in the second band such that the metal pattern 1150 and the ground pattern of the PCB 1200 are connected to each other in the second band higher than the first band. Therefore, a signal in the second band applied through the feed pattern 1120 is radiated through the second radiator 1110m. Therefore, in the first band, the radiator module 1110 operates in a monopole mode.

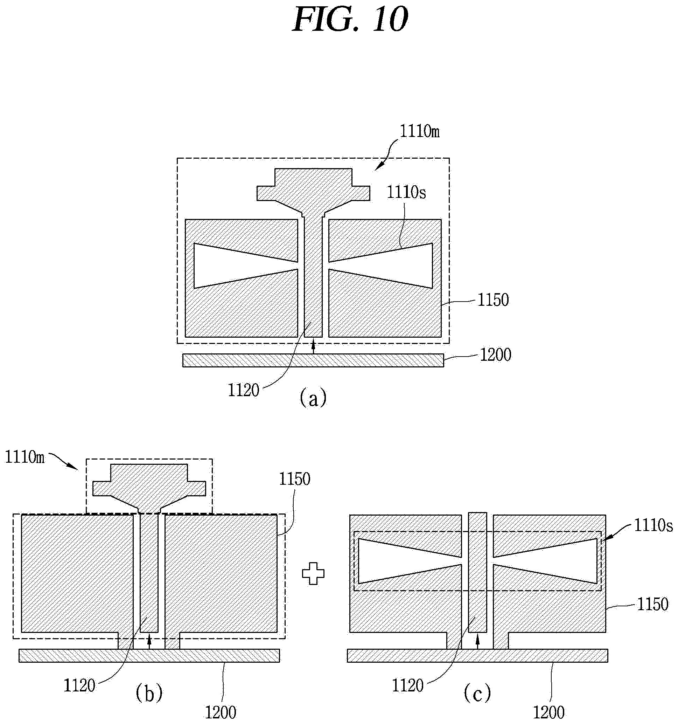

Meanwhile, the wideband antenna structure presented herein may also operate in a slot mode. In this regard, FIG. 10 is a conceptual diagram showing an operating principle for each band of the wideband antenna structure of FIGS. 7 to 9.

Referring to FIGS. 7 to 10, the radiator module 1110 constituting a wideband antenna structure may operate in different modes in the first to third bands. Referring to FIG. 9 and (a) of FIG. 10, in the first band corresponding to the 2.5 GHz band, the radiator module 1110 operates in a combined mode that combines a slot mode and a monopole mode. In this regard, the filter part 1300 constitutes an open circuit between the metal pattern 1150 and the ground pattern of the PCB 1200. The metal pattern 1150 may configure a monopole mode by being coupled to the second radiator 1110m while configuring a slot mode. Accordingly, the metal pattern 1150 may be referred to as a parasitic element. Therefore, the radiator module 1110 in the first band may be referred to as a "monopole with parasitic plate."

Referring to FIG. 9 and (b) of FIG. 10, the radiator module 1110 operates in a monopole mode in a 5 to 6 GHz band corresponding to the second band. In this regard, the filter part 1300 constitutes a short circuit between the metal pattern 1150 and the ground pattern of the PCB 1200. The metal pattern 1150 constitutes a transmission line rather than a slot mode. Accordingly, the metal pattern 1150 provided with the slot region may be equivalent to a transmission line in the second band.

Referring to FIG. 9 and (c) of FIG. 10, the radiator module 1110 operates in a slot mode in a 6 to 7 GHz band corresponding to the third band. In this regard, the filter part 1300 is configured to pass a signal in the third band such that the metal pattern 1150 and the ground pattern of the PCB 1200 are connected to each other in the third band higher than the second band. A signal in the third band applied through the feed pattern 1120 is radiated through the slot radiator 1110s.

Referring to FIGS. 8 and 9, the filter part 1300 may be configured as a band stop filter (BSF). In this regard, the filter part 1300 may be configured as a band stop filter (BSF) that blocks a signal in the first band to operate as an open circuit in the first band, but is not limited thereto. As another example, the filter part 1300 may be configured as a band pass filter that passes a signal in the second and third bands to operate as a short circuit in the second and third bands. As another example, the filter part 1300 may be configured as a high pass filter that blocks a signal in the first band and passes signals in the second and third bands.

The filter part 1300 may include a first filter part 1310 disposed on one side of the feed pattern 1120 and a second filter part 1320 disposed on the other side of the feed pattern 1120. The first filter part 1310 may include a first inductor L1 having a first inductance and a first capacitor C1 having a first capacitance. The first filter part 1310 may be configured such that the first inductor L1 and the first capacitor C1 are connected in parallel to each other. The second filter part 1320 may include a second inductor L2 having a second inductance and a second capacitor C2 having a second capacitance. The second filter part 1320 may be configured such that the second inductor L2 and the second capacitor C2 are connected in parallel to each other. As an example, the first inductance and the second inductance may be set to 2 nH, but are not limited thereto. The first capacitance and the second capacitance may be set to 2 pF, but are not limited thereto.

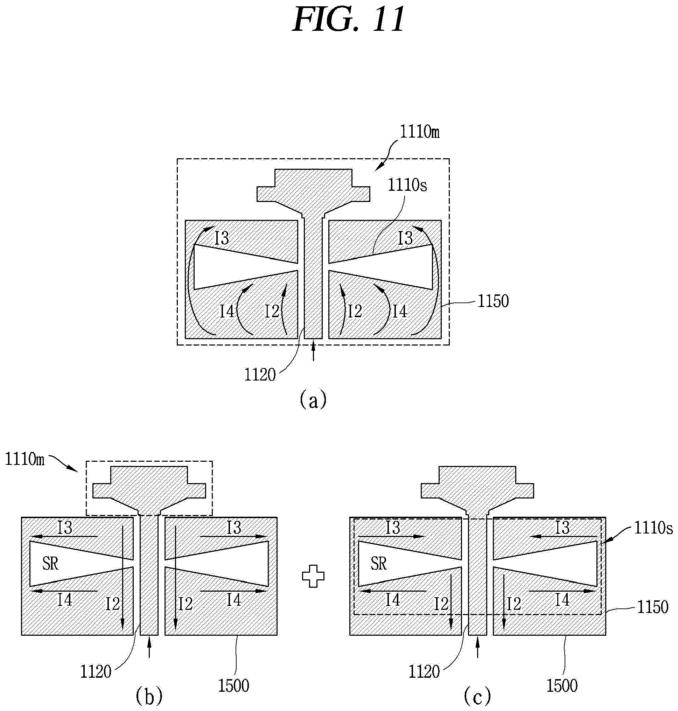

Meanwhile, the antenna structure presented herein allows a wideband operation by forming a different current distribution in the antenna for each band. In this regard, FIG. 11 shows a current distribution for each band of the antenna structure presented herein. Specifically, (a) to (c) of FIG. 11 show current distributions in the first to third bands of the antenna structure presented herein.

Referring to FIG. 10 and (a) of FIG. 11, both the slot radiator 1110s and the second radiator 1100m operate as radiators at 2450 MHz in the first band, and thus the radiator module 1110 operates in a monopole mode + a slot mode. The direction of a first current I1 formed in the second radiator 1110m and the direction of a second current I2 formed in the metal pattern 1150 are formed in the same direction. Meanwhile, a third current I3 and a fourth current I4 are formed along a boundary of the slot region SR, so the radiator module 1110 operates in a mode combining the monopole mode and the slot mode. The slot radiator 1110s radiates a wireless signal in the first band together with the second radiator 1110m.

Referring to FIG. 10 and (b) of FIG. 11, the slot radiator 1110s operates as a transmission line rather than a radiator in a second band higher than the first band. Therefore, in the second band such as 5500 MHz, the second radiator 1110m operates as a radiator and the radiator module 1110 operates in a monopole mode. In this regard, the direction of a first current I1 formed in the feed pattern 1120 and the second radiator 1110m is different from the direction of a second current I2 formed in the metal pattern 1150. Accordingly, the feed pattern 1120 and the metal patterns 1150 formed on both sides of the feed pattern 1120 constitute a CPW transmission line rather than a radiator. A third current I3 and a fourth current I4 formed in the upper and lower regions of the metal region 1150 have different directions with respect to a boundary of the slot region SR. Accordingly, the current does not form a closed loop along the boundary of the slot region SR, so the slot region SR does not operate as a radiator. Therefore, the radiator module 1110 radiates a wireless signal in the second band through the second radiator 1110m.

Referring to FIG. 10 and (c) of FIG. 11, the slot radiator 1110s is configured to radiate a wireless signal through the slot region SR in a third band higher than the first band and the second band. Therefore, in the third band such as 6500 MHz, the slot radiator 1110s operates as a radiator and the radiator module 1110 operates in a slot mode. In this regard, the direction of a first current I1 formed in the second radiator 1110m is different from the direction of a second current I2 formed in the metal pattern 1150. Accordingly, the feed pattern 1120 and the metal patterns 1150 formed on both sides of the feed pattern 1120 constitute a CPW transmission line rather than a radiator. Therefore, the second radiator 1110m does not operate as a radiator such as a monopole antenna. On the contrary, the radiator module 1110 is configured to radiate a wireless signal in the third band through the slot region SR of the slot radiator 1110s in the third band higher than the second band.

In the third band, the third current I3 and the fourth current I4 are formed along the boundary of the slot region SR. A third current I3 and a fourth current I4 formed in the upper and lower regions of the metal pattern 1110m have different directions with respect to a boundary of the slot region SR. Accordingly, the current forms a closed loop along the boundary of the slot region SR, and the slot region SR operates as a radiator. Therefore, the radiator module 1110 operates in a slot mode.

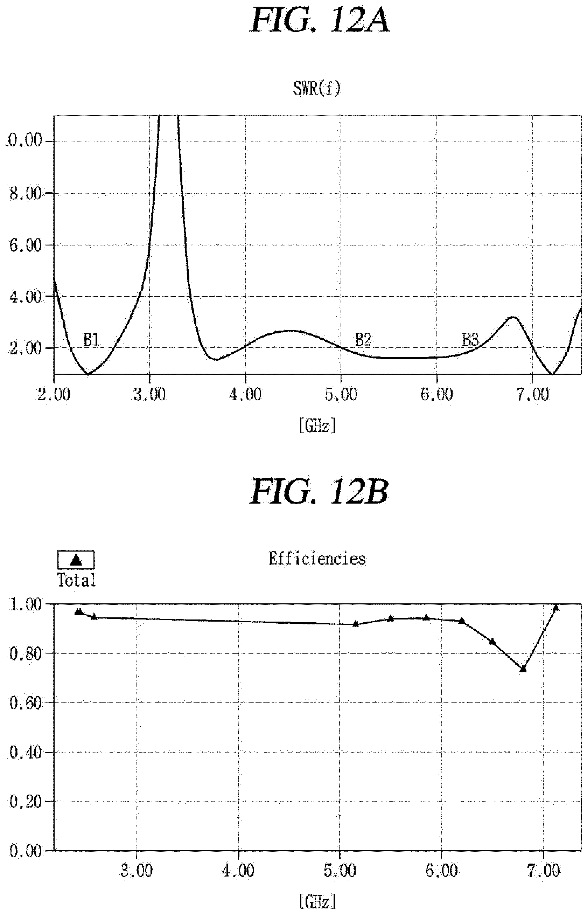

The antenna characteristics of the wideband antenna structure according to this specification, that is, a VSWR characteristic and an antenna efficiency characteristic, will be described. In this regard, FIGS. 12A and 12B show antenna characteristics of the wideband antenna structure shown in FIG. 7 and (a) of FIG. 8. Specifically, FIG. 12A shows a VSWR characteristic of the wideband antenna structure shown in FIG. 7 and (a) of FIG. 8. FIG. 12B shows an antenna efficiency characteristic of the wideband antenna structure shown in FIG. 7 and (a) of FIG. 8.

Referring to FIGS. 7, 8, and 12A, a wideband antenna structure according to this specification operates as an antenna having a VSWR of below 3 in the first band of an about 2.5 GHz band. The wideband antenna structure according to this specification operates as an antenna having a VSWR of below 3 in the second band of an about 5 to 5.5 GHz band. In addition, a wideband antenna structure to which a slot mode and a monopole mode according to this specification are applied operates as an antenna with a VSWR of below 3 in the third band of an about 6 to 6.5 GHz band.

Referring to FIGS. 7, 8, and 12B, the wideband antenna structure according to this specification has an antenna efficiency of above 80% in all the first band of an about 2.5 GHZ band, the second band of an about 5 to 5.5 GHZ band, and the third band of an about 6 to 6.5 GHZ band. Therefore, the wideband antenna structure to which a slot mode and a monopole mode according to this specification are applied has a very high antenna efficiency of above 80% in the full band including the first to third bands.

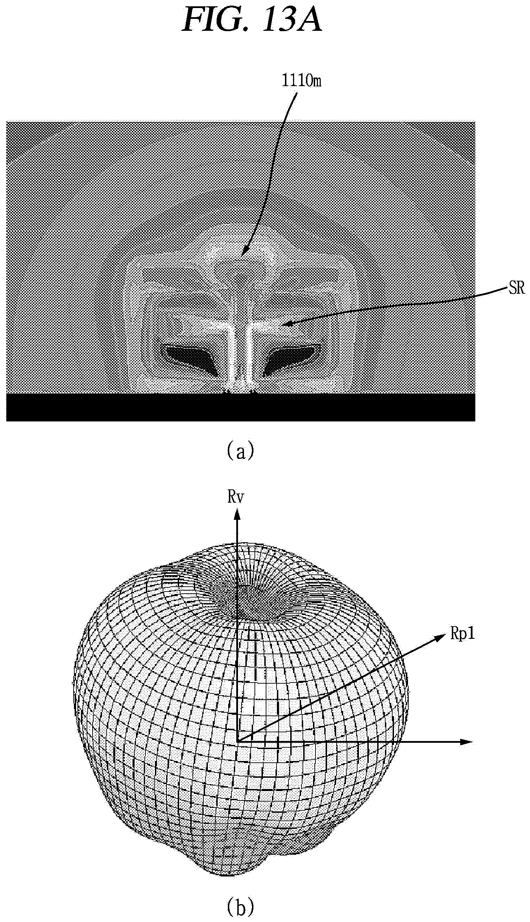

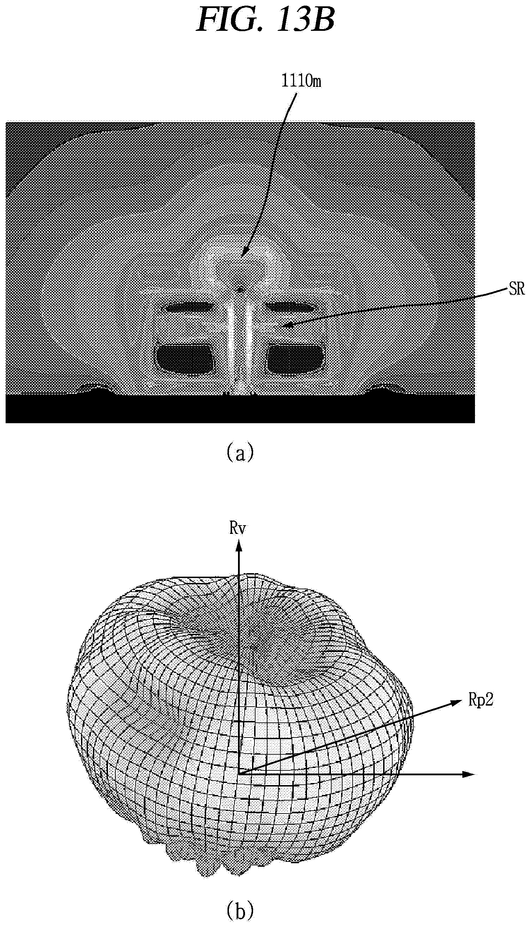

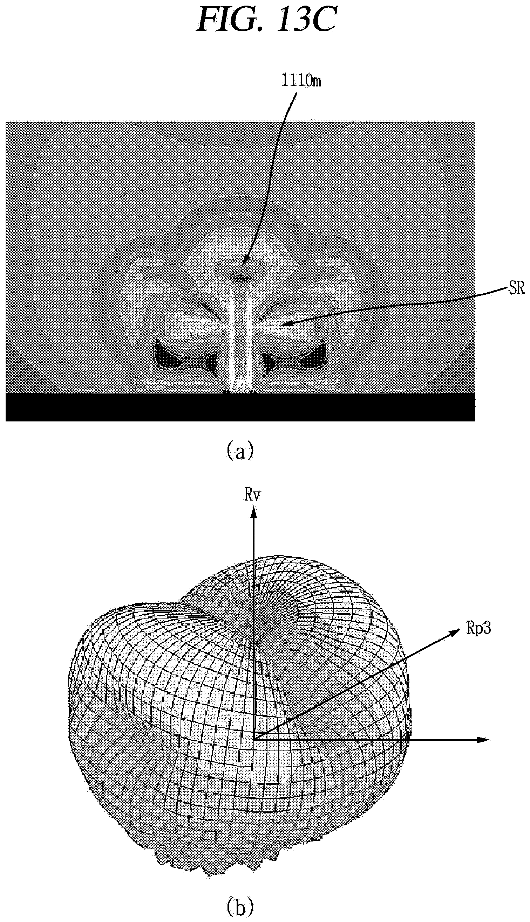

Meanwhile, the wideband antenna structure according to this specification operates as an antenna in the above-described first to third bands. In this regard, FIGS. 13A to 13C show electric field distributions and radiation patterns of the wideband antenna structure according to this specification. Specifically, FIG. 13A shows an electric field distribution and a radiation pattern in a first band of the wideband antenna structure according to this specification. FIG. 13B shows an electric field distribution and a radiation pattern in a second band of the wideband antenna structure according to this specification. FIG. 13C shows an electric field distribution and a radiation pattern in a third band of the wideband antenna structure according to this specification.

Referring to FIGS. 9 to 11 and (a) of FIG. 13A, an electric field distribution in a region corresponding to the second radiator 1110m in a first band appears higher than that of the surrounding region. Furthermore, in the first band, an electric field distribution corresponding to the slot region SR appears higher than that of the surrounding region. Therefore, in the first band, the radiator module 1110 operates in a monopole mode + a slot mode.

Referring to FIGS. 9 to 11 and (a) of FIG. 13B, an electric field distribution in a region corresponding to the second radiator 1110m in a second band appears higher than that of the surrounding region. On the contrary, an electric field distribution corresponding to the slot region SR in the second band is not higher than that of the surrounding region. Therefore, in the second band, the radiator module 1110 operates in a monopole mode.

Referring to FIGS. 9 to 11 and (a) of FIG. 13C, an electric field distribution in a region corresponding to the second radiator 1110m in a third band is not higher than that of the surrounding region. In particular, an electric field distribution is formed to be low near the first region 1111 of the second radiator 1110m. Therefore, the second radiator 1110m in the third band is not configured to radiate a wireless signal. On the contrary, in the third band, an electric field distribution corresponding to the slot region SR appears higher than that of the surrounding region. Therefore, in the third band, the radiator module 1110 operates in a slot mode.

Referring to FIGS. 9 to 11 and (b) of FIG. 13A, a radiation pattern in the first band forms a low elevation beam pattern. The radiation pattern in the first band forms a beam peak in a peak region Rp1 corresponding to a predetermined angle with respect to a horizontal plane. Meanwhile, the radiation pattern in the first band forms a null pattern in a vertical region Rv with respect to the horizontal plane.

Referring to FIGS. 9 to 11 and (b) of FIG. 13B, a radiation pattern in the second band forms a low elevation beam pattern. The radiation pattern in the first band forms a beam peak in a peak region Rp2 corresponding to a predetermined angle with respect to a horizontal plane. Meanwhile, the radiation pattern in the second band forms a null pattern in a vertical region Rv with respect to the horizontal plane.

Referring to FIGS. 9 to 11 and (b) of FIG. 13C, a radiation pattern in the third band forms a low elevation beam pattern. The radiation pattern in the third band forms a beam peak in a peak region Rp3 corresponding to a predetermined angle with respect to a horizontal plane. Meanwhile, the radiation pattern in the third band forms a null pattern in a vertical region Rv with respect to the horizontal plane.

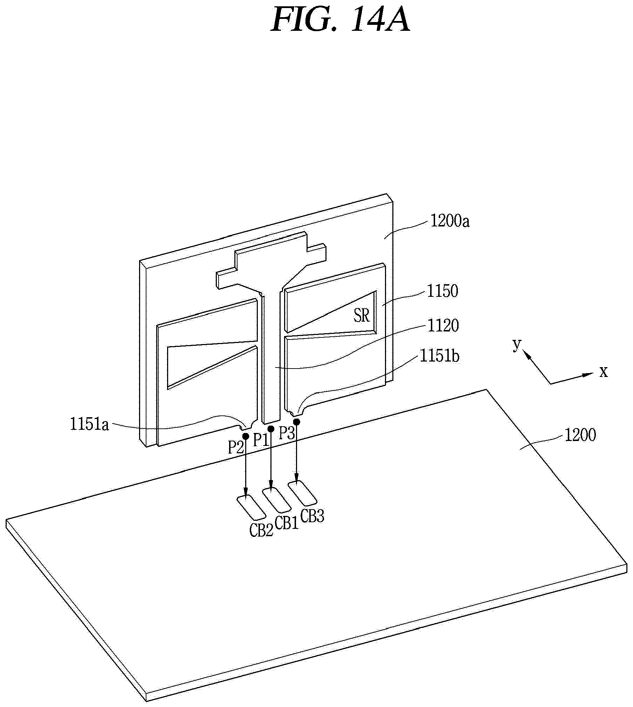

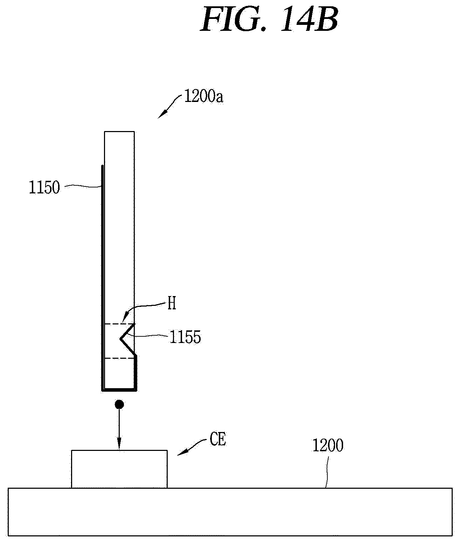

Meanwhile, an antenna PCB on which the wideband antenna element according to this specification is disposed may be coupled to a main PCB to be electrically connected thereto. In this regard, FIGS. 14A and 14B show a structure in a case where an antenna PCB disposed with a wideband antenna element is implemented on a dielectric substrate.

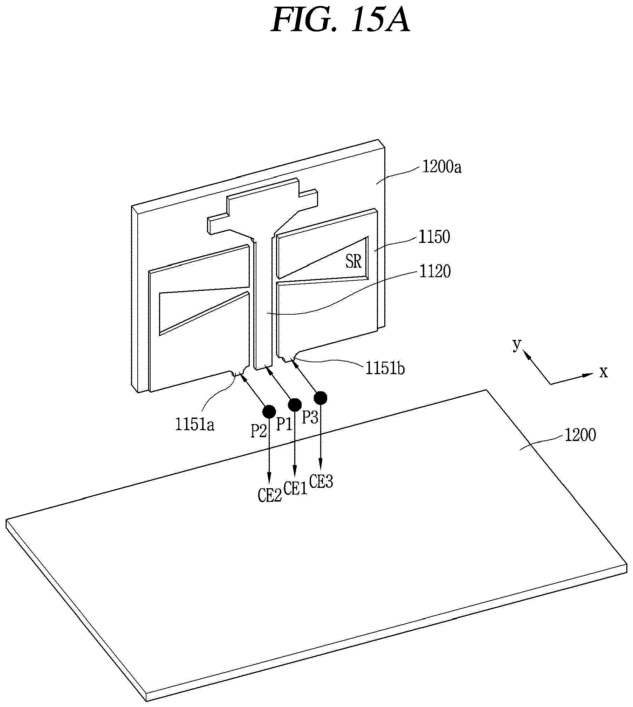

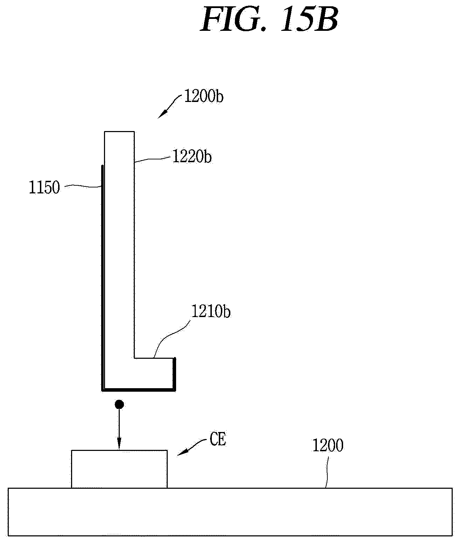

Meanwhile, FIGS. 15A and 15B show a structure in a case where an antenna PCB disposed with a wideband antenna element is implemented on a flexible substrate.

Referring to FIGS. 14A to 15B, the wideband antenna structure of this specification may be implemented on a cross section of a dielectric substrate or flexible substrate. Accordingly, it may be implemented and produced at a low price, and the antenna pattern may also be implemented in a curved shape by being implemented on a flexible substrate.

Referring to FIGS. 9, 14A, and 14B, an antenna PCB 1200b is disposed perpendicular to the PCB 1200. An end portion of the feed pattern 1120 may be connected to a transmission line of the PCB 1200 through conductive blocks CB1 to CB3 coupled to the PCB 1200. The transmission line of the PCB 1200 may also be implemented as a CPW transmission line similar to a transmission line structure of the antenna PCB 1200b, but is not limited thereto.

The feed pattern 1120 may be connected to a signal line on the PCB 1200 at a first point P1 through the first conductive block CB1. The ground pattern 1150 disposed on at least one side of the feed pattern 1120 may be connected a ground of the PCB 1200 through the second and third conductive blocks CB2, CB3 coupled to the filter part 1300 and the PCB 1200 at a second point P2 and a third point P3. The ground pattern 1150 may be connected to the ground of the PCB 1200 at the second point P2 and the third point P3. The ground pattern 1150 may be connected to the ground of the PCB 1200 at the second point P2 and the third point P3 through a first ground connection part 1151a and a second ground connection part 1152 disposed on a lower part of the flexible substrate 1200b.

The antenna PCB 1200a may be formed of a dielectric substrate. The metal pattern 1150 may be disposed to extend from one surface of the dielectric substrate to the other surface thereof along a lower surface. A hole H is disposed on the other surface of the dielectric substrate to fix the dielectric substrate to the PCB 1200 through an insertion structure 1155 inserted into the hole H. The insertion structure 1155 may be disposed along an inner surface of the hole H, but is not limited thereto.

Referring to FIGS. 9, 15A, and 15B, the antenna PCB may be formed of a flexible substrate 1200b. When the antenna PCB is implemented with the flexible substrate 1200b, it may be disposed in a structure that feeds power to the radiator module 1110 through a conductive elastin structure CE attached to the PCB 1200 using SMT/SMD, or the like. The conductive elastin structure CE may be implemented as a conductive silicon ball, but is not limited thereto.

The conductive elastin structure CE may include a first conductive elastin structure CE1 coupled to a signal line on the PCB 1200, and second and third conductive elastin structures CE2, CE3 coupled to a ground pattern disposed on at least one side of the signal line. The feed pattern 1120 may be connected to a signal line on the PCB 1200 through the first conductive elastin structure CE1. The ground pattern 1150 disposed on at least one side of the feed pattern 1120 may be connected to the ground of the PCB 1200 through the second and third conductive elastin structures CE2, CE3 coupled to the filter part 1300 and the PCB 1200. The ground pattern 1150 may be connected to the ground of the PCB 1200 at the second point P2 and the third point P3. The ground pattern 1150 may be connected to the ground of the PCB 1200 at the second point P2 and the third point P3 through a first ground connection part 1151a and a second ground connection part 1152 disposed on a lower part of the flexible substrate 1200b.

The metal pattern 1150 may be disposed to extend from one surface of the flexible substrate 1200b to a protruding portion 1210b on the other surface thereof along a lower surface. The metal pattern 1150 may not be disposed on a flat portion 1220b of the other surface of the flexible substrate 1200b, but may be disposed to extend to the protruding portion 1210b.

Meanwhile, the wideband antenna structure according to this specification may be implemented on a rib structure of the top cover 1320. Referring to FIG. 6 and FIGS. 14A to 15B, an antenna PCB 1210a, 1210b may be implemented with a rib structure 1310r, 1320r of the bottom cover 1310 or the top cover 1320 in the antenna module 1000, or attached to the rib structure 1310r, 1320r. The metal pattern 1150 of the antenna PCB 1210a, 1210b may be disposed to surround inner and outer regions of the rib structure 131Or, 1320r.

In this regard, the antenna PCB 1210a, 1210b may be disposed on the rib structure 1320r of the top cover 1320. As another example, the antenna PCB 1210a, 1210b may be disposed on the rib structure 1310r of the bottom cover 1310. As another example, the antenna PCB 1210a, 1210b may be disposed between the rib structure 1310r of the bottom cover 1310 and the rib structure 1320r of the top cover 1320. The rib structure 1310r of the bottom cover 1310 may be disposed on a rear side of the antenna PCB 1210a, 1210b, and the rib structure 1320r of the top cover 1320 may be disposed on a front side thereof. Accordingly, the antenna PCB 1210a, 1210b may be fixedly disposed by the rib structure 1320r, 1310r on front and rear sides thereof.

The rib structure of the top cover 1310 may extend to the PCB 1200 so as to be coupled to the conductive blocks CB1 to CB3 on the PCB 1200. It will be clearly understood by those skilled in the art that various changes and modifications to the aforementioned embodiments related to the antenna module are made without departing from the idea and scope of the present disclosure. Therefore, it should be understood that such various modifications and alternations for the implementations fall within the scope of the appended claims.

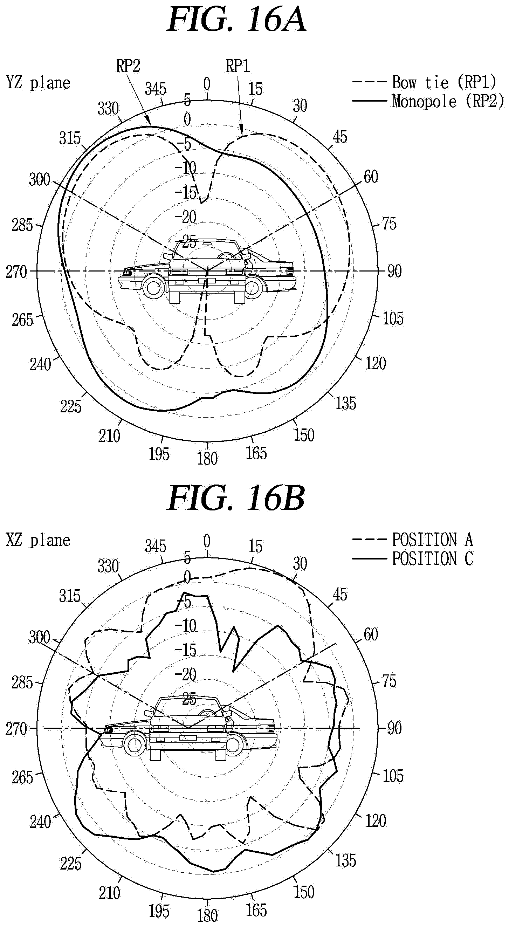

Meanwhile, the wideband antenna structure presented herein may be configured to implement a low elevation radiation pattern to communicate with surrounding vehicles and RSUs when mounted on a vehicle, as shown in FIGS. 3A to 3C. In this regard, FIGS. 16A and 16B show radiation patterns of a wideband antenna structure presented herein in vertical and horizontal directions. Specifically, FIG. 16A shows a radiation pattern of the wideband antenna structure presented herein in a vertical direction. FIG. 16B shows a radiation pattern of the wideband antenna structure presented herein in a horizontal direction.

Referring to FIGS. 8, 9, and 16A, the peak angle of a radiation pattern in the third band radiating a wireless signal through the slot region SR of the bow-tie shaped slot radiator 1110s is formed below 30 degrees with respect to a horizontal plane. Accordingly, the wideband antenna structure presented herein is configured to implement a low elevation radiation pattern in a slot mode. Meanwhile, in the second band that radiates a wireless signal through the second radiator 1110m, the peak angle of a radiation pattern is formed below 30 degrees with respect to the horizontal plane. Accordingly, the wideband antenna structure presented herein is configured to implement a low elevation radiation pattern even in a monopole mode.

When radiating a wireless signal through the slot region SR, a wireless signal may be radiated to front and rear sides of the slot region SR. Accordingly, as shown in FIG. 16A, a radiation pattern in a slot mode is formed to have more symmetrical left and right sides in a vertical direction than that in a monopole mode. Meanwhile, in the first band operating in a monopole mode + a slot mode, a radiation pattern in a vertical direction may be implemented as a combination of a first radiation pattern RP1 in the slot mode and a second radiation pattern RP2 in the monopole mode.

Referring to FIGS. 8, 9, and 16B, a radiation pattern in a horizontal direction forms an isotopic beam pattern in all directions. Therefore, a signal may be received from all directions with respect to a horizontal plane of a vehicle. Meanwhile, the wideband antenna structure in this specification may be disposed at different locations on the antenna PCB 1200 of the antenna module 1000 as shown in FIG. 5.

In this regard, the antenna module 1000 may be disposed inside a metallic roof of the vehicle, and a non-metallic structure may be disposed in an upper region so as to allow a wireless signal radiated through the antenna module 1000 to pass therethrough. The radiator module 1110 may be disposed at different positions on the PCB 1200, for example, at different positions A and C in FIG. 14B. As the radiator module 1110 is disposed at different positions A and C on the PCB 1200, the effect of surrounding metal changes. Referring to FIG. 14B, it may be determined that the effect of surrounding metal at position C is greater than that at position A. It is determined that both structures in which the radiator module 1110 is disposed at position A and position C have an isotropic radiation pattern on a horizontal plane of the vehicle. Accordingly, the ability to receive signals in all directions on the horizontal plane of the vehicle is improved.

Therefore, the wideband antenna structure presented herein may implement a low elevation radiation pattern in a vertical direction with respect to the horizontal plane of the vehicle so as to implement an isotropic radiation pattern in a horizontal direction. In this regard, referring to FIGS. 7 to 9 and FIG. 16A, a wireless signal is radiated at an angle tilted by a predetermined angle in a vertical direction with respect to a bottom surface of the bottom cover 1310 of the antenna module 1000. A wireless signal is radiated to one surface and the other surface of the antenna PCB 1200a at an angle tilted by a predetermined angle in a vertical direction with respect to the bottom surface of the bottom cover 1310. Referring to FIGS. 5, 7 to 9, and 16B, a wireless signal is radiated in all directions in a horizontal direction with respect to the bottom surface of the bottom cover 1310.

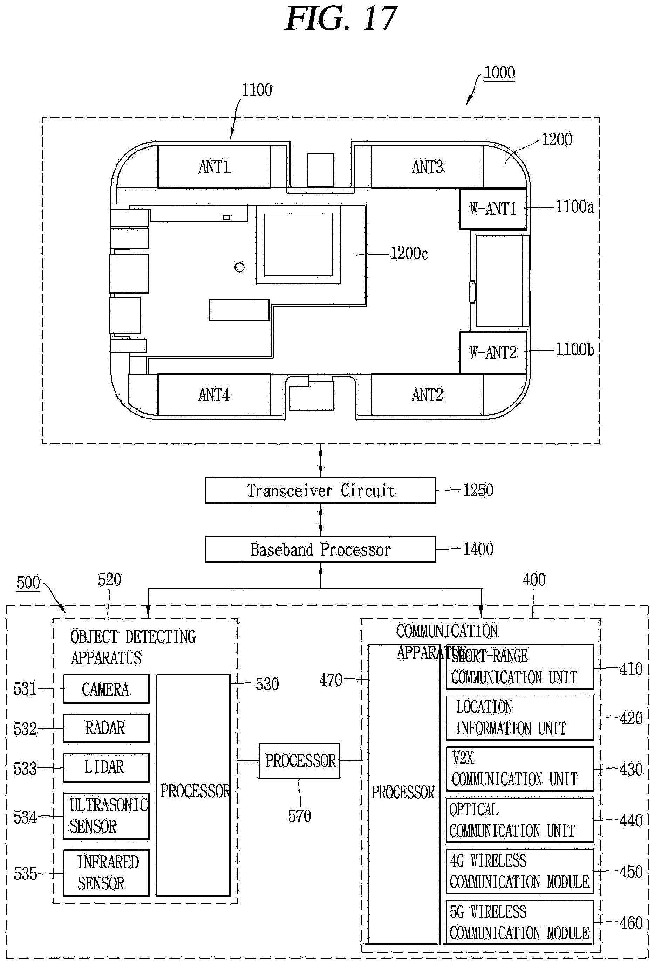

Meanwhile, FIG. 17 shows a configuration diagram of an antenna system according to an embodiment and a vehicle on which the antenna system is mounted. Specifically, FIG. 17 shows a configuration diagram of a vehicle in which an antenna module corresponding to an antenna system is disposed inside a vehicle roof to perform communication with nearby electronic devices, vehicles, and infrastructures.

Referring to FIG. 17, the wideband antenna module 1000 may be mounted on the vehicle. The antenna module 1000 may perform short-range communication, wireless communication, V2X communication, and the like by itself or through the communication apparatus 400. To this end, the baseband processor 1400 may perform control such that a signal is received from or transmitted to the adjacent vehicle, the RSU, and the base station through the antenna module 1000.

Alternatively, the baseband processor 1400 may perform control such that a signal is received from or transmitted to the adjacent vehicle, the RSU, the adjacent object, and the base station through the communication apparatus 400. Here, the information related to adjacent objects may be acquired through the object detecting apparatus such as the camera 531, the radar 532, the lidar 533, and the sensors 534 and 535 of the vehicle 300. Alternatively, the baseband processor 1400 may control the communication device 400 and the antenna module 1000 such that a signal is received from or transmitted to the adjacent vehicle, the RSU, the adjacent object, and the base station.

Meanwhile, referring to FIGS. 1A to 17, the vehicle 500 having the antenna module 1000 may include the plurality of antennas 1100, the transceiver circuit 1250, and the baseband processor 1400. The vehicle 500 may further include the object detecting apparatus 520. The vehicle 500 may further include the communication apparatus 400. Here, the communication apparatus 400 may be configured to perform wireless communication through the antenna unit.

Referring to FIGS. 1A to 17, the vehicle 500 may be provided with the antenna module 1000. The antenna module 1000 may be disposed below a roof of the vehicle, and configured to communicate with at least one of an adjacent vehicle, a road side unit (RSU), and a base station through a processor. The antenna module 1000 may perform a telematics operation through wireless communication in the vehicle, and thus may also be referred to as a telematics module. In this regard, the antenna PCB 1200 in the antenna module 1000 may be coupled to a telematics module 1200c that performs a telematics function. In this regard, the antenna PCB 1200 and the telematics module 1200c may be coupled to interface with each other on the same plane.

Referring to 1A to 17, the vehicle 500 provided with the antenna module 1000 according to another aspect of this specification will be described. The vehicle 500 includes the antenna module 1000 disposed below the roof of the vehicle. The vehicle 500 may further include the processor 1400 disposed inside or outside the antenna module 1000 and configured to communicate with at least one of an adjacent vehicle, a road side unit (RSU), and a base station.

The antenna module 1000 may include a PCB 1200, a bottom cover 1310, a top cover 1320, and an antenna PCB 1200a. A printed circuit board (PCB) 1200 may be configured to form a transmission line through which a wireless signal is transmitted. The bottom cover 1310 is configured to be attached to a vehicle. The bottom cover 1310 may be configured such that the PCB 1200 is disposed thereon. The top cover 1320 may be fastened to the bottom cover 1310 to accommodate the PCB 1200 therein.

The antenna PCB 1200a may be operably coupled to the PCB 1200. A wireless signal transmitted through a transmission line of the PCB 1200 may be transmitted to the antenna PCB 1200a.

The antenna module 1000 may include a PCB 1200, a bottom cover 1310, an antenna PCB 1200a, and a filter part 1300. A transmission line may be disposed on the PCB 1200. The bottom cover 1310 may be configured such that the PCB 1200 is disposed therein to be attached to a vehicle. The antenna PCB 1200a is coupled to the PCB 1200, and disposed with the feed pattern 1120 on one surface thereof and the metal pattern 1150 disposed on at least one of one side and the other side of the feed pattern 1120. The filter part 1300 is configured to electrically connect the metal pattern 1150 and the ground pattern of the PCB 1200 in a specific band.

The antenna PCB 1200a may include a slot radiator 1100s and a second radiator 1100m. The slot radiator 1100s may be referred to as a first radiator. The second radiator 1100m may be referred to as a monopole radiator or a patch radiator. The slot radiator 1100s is configured to radiate a wireless signal through a slot region SR disposed to have a first length L1 in a first axis direction inside the metal pattern 1150. The second radiator 1100m is connected to an end portion of the feed pattern 1120, and disposed in an upper region of the metal pattern 1150 in a second axis direction.

The second radiator 1100m may be divided into a plurality of radiation regions. The second radiator 1100m may include a first region R1 and a second region R2. The first region R1 may be connected to an end portion of the feed pattern 1120, and configured to increase in width in the second axis direction. The second region R2 is connected to an end portion of the first region R1 in the second axis direction, and configured to have a second length L2 in the first axis direction and a second width W2 in the second axis direction.

The slot radiator 1100s and the second radiator 1100m may constitute the radiator module 1100. The radiator module 1100 may operate as a different radiation mechanism for each band. Accordingly, the radiator module 1100 may operate in a wide bandwidth in the first to third bands, which are different frequency bands.

In this regard, the slot radiator 1110s and the second radiator 1110m may be configured to radiate a first signal in the first band. The second radiator 1110m may be configured to radiate a second signal in a second band higher than the first band. The slot radiator 1110s may be configured to radiate a third signal in a third band higher than the second band.

The processor 1400 may be configured to control the filter part 1300 through the transceiver circuit 1250. The processor 1400 may control the filter part 1300 to block the first signal in the first band such that the metal pattern 1150 and the ground pattern of the PCB 1200 are not connected to each other in the first band. The processor 1400 may control the filter part 1300 such that the second signal in the second band and the third signal in the third band pass therethrough in the second and third bands higher than the first band. The processor 1400 controls the filter part 1300 to connect the metal pattern 1150 and the ground pattern of the PCB 1200 such that the second signal in the second band and the third signal in the third band pass therethrough.

In this regard, the first signal in the first band applied through the feed pattern 1120 may be radiated through the slot radiator 1110s and the second radiator 1110m. Accordingly, the first signal in the first band is radiated in a slot mode + a monopole mode. The second signal in the second band applied through the feed pattern 1120 may be radiated through the second radiator 1110m. Accordingly, the second signal in the second band is radiated in a monopole mode. The third signal in the third band applied through the feed pattern 1120 is radiated through the slot radiator 1110s. Accordingly, the third signal in the third band is radiated in a slot mode.

Several types of antenna elements may be disposed in the antenna module 1000. Each type of antenna element may also be implemented with a plurality of antenna elements to implement multi-input multi-output (MIMO). A plurality of antennas may be provided for 4G/5G communication. The plurality of antennas may include a first antenna (ANT1) and a second antenna (ANT2). The plurality of antennas may include a third antenna (ANT3) and a fourth antenna (ANT4).

Meanwhile, the plurality of antennas may be disposed for WiFi communication. As an example, the plurality of antennas for WiFi communication may include a first antenna (W-ANT1) 1100a and a second antenna (W-ANT2) 1100b. Therefore, the antenna module 1100 may include the first antenna (W-ANT1) 1100a and the second antenna (W-ANT2) 1100b consisting of the slot radiator 1110s and the second radiator 1100m. Locations where the first antenna (W-ANT1) 1100a and the second antenna (W-ANT2) 1100b are disposed are not limited to specific locations on the antenna PCB 1200a of FIG. 15 and may be changed depending on the application.

The processor 1400 may control to perform multi-input multi-output (MIMO) in the first band through the first antenna (W-ANT1) 1100a and the second antenna (W-ANT2) 1100b. The processor 1400 may control to perform to transmit and receive a signal in the first band only through the first antenna (W-ANT1) 1100a and the second antenna (W-ANT2) 1100b. Therefore, the processor 1400 may switch between a multiple transmission mode such as a MIMO mode and a single transmission mode in the first band depending on the communication environment.

The processor 1400 may control to perform multi-input multi-output (MIMO) in a second band and/or a third band higher than the first band through the first antenna (W-ANT1) 1100a and the second antenna (W-ANT2) 1100b. The processor 1400 may control to transmit and receive a signal in the second band and/or the third band through the first antenna (W-ANT1) 1100a or the second antenna (W-ANT2) 1100b. Therefore, the processor 1400 may switch between a multiple transmission mode such as a MIMO mode and a single transmission mode in the second band and/or the third band depending on the communication environment.

The transceiver circuit 1250 may be operably coupled to each radiator module 1100. The processor 1400 may be operably coupled to the transceiver circuit 1250. The processor 1400 may be a baseband processor corresponding to a modem, but is not limited thereto and may be any processor that controls the transceiver circuit 1250. The processor 1400 of the vehicle may be implemented as a network access device (NAD).

The transceiver circuit 1250 may be operably coupled to the MIMO antennas ANT1 to ANT4. The transceiver circuit 1250 may include a front end module (FEM) such as a power amplifier or a receiving amplifier. As another example, the front end module (FEM) may be disposed between the transceiver circuit 1250 and the antenna, separately from the transceiver circuit 1250. The transceiver circuit 1250 may control the amplitude and/or phase of signals transmitted to the MIMO antennas ANT1 to ANT4 or control only some antenna modules to operate by adjusting the gain or input or output power of the power amplifier or the receiving amplifier.

The processor 1400 may be operably coupled to the transceiver circuit 1250 and may be configured to control the transceiver circuit 1250. The processor 1400 may control the transceiver circuit 1250 to control the amplitude and/or phase of the signals transmitted to the MIMO antennas ANT1 to ANT4 or to operate only some antenna modules. The processor 1400 may perform communication with at least one of the adjacent vehicle, the road side unit (RSU), and the base station through the transceiver circuit 1250.

In a case where there is a need to simultaneously receive information from various entities such as the adjacent vehicle, the RSU, and the base station for autonomous driving, etc., information may be received and transmitted through MIMO. Therefore, the vehicle may receive different information from various entities at the same time to improve its communication capacity. Therefore, the communication capacity of the vehicle can be improved through the MIMO without increasing a bandwidth.

Alternatively, the vehicle may simultaneously receive the same information from various entities, so as to improve reliability of surrounding information and decrease latency. Accordingly, Ultra Reliable Low Latency Communication (URLLC) can be performed in the vehicle and the vehicle can operate as a URLLC UE. To this end, a base station that performs scheduling may preferentially allocate a time slot for the vehicle operating as the URLLC UE. For this purpose, some of specific time-frequency resources already allocated to other UEs may be punctured.

As described above, the plurality of antennas ANT1 to ANT4 for 4G/5G communication within the antenna module 1000 may operate in the full band including the low band (LB), the mid band (MB), and the high band (HB). Here, the low band (LB) may be referred to as the first (frequency) band and the mid band (MB) and the high band (HB) may be referred to as the second (frequency) band. As another example, when the antenna system 1000 operates in the mid band (MB) and the high band (HB), the mid band (MB) is referred to as a first (frequency) band and the high band (HB) is referred to as a second (frequency) band. The 5G sub-6 band may be the same band as the LTE band in case of LTE re-farming. When 5G NR operates in a band separate from LTE, it may operate in the high band (HB) or a higher band. The 5G sub-6 band operating in the high band (HB) or higher band may also be referred to as a second (frequency) band.

The baseband processor 1400 can perform MIMO through some of the plurality of antenna elements ANT1 to ANT4 in the first frequency band. Also, the baseband processor 1400 can perform MIMO through some of the plurality of antenna elements ANT1 to ANT4 in the second frequency band. In this regard, the baseband processor 1400 can perform MIMO by using antenna elements that are sufficiently spaced apart from each other and disposed by being rotated at a predetermined angle. This can improve isolation between the first and second signals within the same band.

The baseband processor 1400 may control the transceiver circuit 1250 to receive the second signal in the second band while receiving the first signal in the first band through one of the first to fourth antennas ANT1 to ANT4. In this case, there may be provided an advantage that the baseband processor 1400 can advantageously perform carrier aggregation (CA) through one antenna.

Alternatively, the baseband processor 1400 may control the transceiver circuit 1250 to receive the second signal in the second band through one of the third antenna ANT3 and the fourth antenna ANT4 while receiving the first signal in the first band through one of the first antenna ANT1 and the second antenna ANT2. In this case, there may be provided an advantage that each antenna can be designed to optimally operate in a corresponding band.

Therefore, the baseband processor 1400 may perform carrier aggregation (CA) through a band in which the first frequency band and the second frequency band are combined. When it is necessary to receive a large amount of data for autonomous driving or the like, reception in a broad band may be allowed through the CA.

Accordingly, eMBB (Enhanced Mobile Broad Band) communication can be performed in the vehicle and the vehicle can operate as an eMBB UE. To this end, the base station that performs scheduling may allocate a wideband frequency resource to the vehicle that operates as the eMBB UE. To this end, the CA may be performed on frequency bands that are available, except for frequency resources already allocated to other UEs.

Regard the frequency band, the low band (LB), the mid band (MB), and the high band (HB) may be referred to as the first band, the second band, and the third band, respectively. The antenna system 1000 may operate as a single antenna in the first band, the second band, and the third band corresponding to the low band (LB), the middle band (MB), and the high band (HB). In this regard, the processor 1400 may determine a resource region allocated through a physical downlink control channel (PDCCH). The processor 1400 may control the transceiver circuit 1250 to perform carrier aggregation in two or more of the first to third bands based on the allocated resource region.

The processor 1400 may perform MIMO in an EN-DC state through the first to fourth antennas ANT1 to ANT4. For example, the processor 1400 may perform an EN-DC operation through the first antenna ANT1 and the second antenna ANT2, and MIMO through the third antenna ANT3 and the fourth antenna ANT4.

In this regard, when the EN-DC operation is performed between the 4G/5G communication system and the WiFi communication system using different bands, the processor 1400 may perform the EN-DC operation through a plurality of antennas in one antenna system. Accordingly, an interference level between MIMO streams using the same band can be reduced. On the other hand, when the EN-DC operation is performed between the 4G and 5G communication systems using the same band, the processor 1400 may perform the EN-DC operation through a plurality of antennas in different antenna systems. In this case, in order to reduce the interference level in the low band (LB), the MIMO operation through the plurality of antennas in the same antenna system may be performed in the mid band (MB) or higher.

It will be clearly understood by those skilled in the art that various modifications and alternations for the aforementioned implementations related to the antenna system having the plurality of antennas, the vehicle having the antenna system, and the control operations thereof are made without departing from the idea and scope of the present disclosure. Therefore, it should be understood that such various modifications and alternations for the implementations fall within the scope of the appended claims.

In the above, an antenna module having a wideband antenna element disposed in a vehicle and a vehicle equipped with the antenna module have been described. The technical effects of such an antenna module having a wideband antenna element in a vehicle and a vehicle equipped with the antenna module will be described as follows.

According to this specification, it aims to provide a multi-mode wideband antenna element capable of providing Wi-Fi communication services in various bands while being disposed in a vehicle.

According to this specification, an antenna element operating in a wide bandwidth may be implemented through a structure in which antenna elements operating in a monopole mode and a slot mode are connected to a feed line on a PCB.

According to this specification, a wideband antenna element with a high efficiency while operating in a wide bandwidth may be implemented through an antenna element operating in a monopole mode fed on a CPW transmission line and a slot mode having a bow-tie type slot shape.

According to this specification, a filter may be implemented to selectively connect ground patterns disposed on both sides of a feed line of an antenna PCB to a ground of the PCB, thereby implementing a wideband antenna operating in different modes in different bands.

According to this specification, a wideband antenna element may be disposed inside a non-metallic antenna module, thereby maintaining antenna performance at a predetermined level even when the exterior of a vehicle body or roof is formed of a metal material.

According to this specification, a structure for mounting an antenna system capable of operating in a wideband on a vehicle to support various communication systems may be presented.

Further scope of applicability of the present disclosure will become apparent from the following detailed description. It should be understood, however, that the detailed description and specific examples, such as the preferred embodiment of the disclosure, are given by way of illustration only, since various changes and modifications within the spirit and scope of the disclosure will be apparent to those skilled in the art.

In relation to the foregoing description, the antenna system mounted in the vehicle and the operation of controlling the same may be implemented by software, firmware, or a combination thereof. Meanwhile, the design of the antenna system mounted in the vehicle and the configuration of controlling the antenna system may be implemented as computer-readable codes in a program-recorded medium. The computer-readable medium may include all types of recording devices each storing data readable by a computer system. Examples of such computer-readable media may include hard disk drive (HDD), solid state disk (SSD), silicon disk drive (SDD), ROM, RAM, CD-ROM, magnetic tape, floppy disk, optical data storage element and the like. Also, the computer-readable medium may also be implemented as a format of carrier wave (e.g., transmission via an Internet). The computer may also include a controller of a terminal or vehicle, namely, a processor. Therefore, the detailed description should not be limitedly construed in all of the aspects, and should be understood to be illustrative. The scope of the invention should be determined by reasonable interpretation of the appended claims and all changes that come within the equivalent scope of the invention are included in the scope of the disclosure.

## Claims

1. An antenna module mounted on a vehicle, the antenna module comprising:
a PCB having a transmission line disposed thereon;
an antenna PCB coupled to the PCB, and disposed with a feed pattern on one surface thereof and a metal pattern disposed on at least one of one side and the other side of the feed pattern; and
a filter part configured to electrically connect the metal pattern and a ground pattern of the PCB in a specific band,
wherein the antenna PCB comprises:
a slot radiator configured to radiate a wireless signal through a slot region disposed to have a first length in a first axis direction inside the metal pattern; and
a second radiator connected to an end portion of the feed pattern, and disposed in an upper region of the metal pattern in a second axis direction.

2. The antenna module of claim 1, wherein the slot radiator and the second radiator constitute a radiator module,
wherein the second radiator comprises:
a first region connected to an end portion of the feed pattern, and configured to increase in width in the second axis direction; and
a second region connected to an end portion of the first region in the second axis direction, the second region having a second length in the first axis direction and a second width in the second axis direction, and
wherein the second radiator is configured to radiate a wireless signal in a first band.

3. The antenna module of claim 2, wherein the direction of a first current formed in the second radiator and the direction of a second current formed in the ground pattern are formed in the same direction such that the radiator module operates in a monopole mode, and
wherein the ground pattern including the slot radiator operates as a ground of the feed pattern that feeds the second radiator.

4. The antenna module of claim 2, wherein the second region comprises a parasitic metal pattern disposed to extend a length of the second region to one side and the other side thereof from end portions of the first region in the first axis direction.

5. The antenna module of claim 2, wherein the slot radiator is disposed to have a first length in a first axis direction with respect to a center point of the slot region, and configured to gradually increase in width in a second axis direction with respect to the center point, and
wherein the slot radiator is configured to radiate a wireless signal in a second band higher than the first band together with the radiator.

6. The antenna module of claim 5, wherein the direction of a first current formed in the second radiator is different from the direction of a second current formed in the ground pattern, and a third current and a fourth current are formed along a boundary of the slot region such that the radiator module operates in a mode combining a monopole mode and a slot mode, and
wherein the directions of the third current and the fourth current formed in upper and lower regions of the metal pattern are formed differently with respect to the boundary of the slot region.

7. The antenna module of claim 5, wherein the direction of a first current formed in the third radiator and the direction of a second current formed in the ground pattern are formed differently, and
wherein the radiator module is configured to radiate a wireless signal through the slot radiator in a third band higher than the second band.

8. The antenna module of claim 7, wherein a third current and a fourth current are formed along the boundary of the slot region such that the radiator module operates in a mode combining a monopole mode and a slot mode, and
wherein the directions of the third current and the fourth current formed in upper and lower regions of the metal pattern are formed in the same direction with respect to the boundary of the slot region.

9. The antenna module of claim 1, wherein the filter part is configured to block a signal in a first band such that the metal pattern and the ground pattern of the PCB are not connected to each other in the first band, and
wherein a signal in the first band applied through the feed pattern is radiated through the second radiator.

10. The antenna module of claim 9, wherein the filter part is configured to pass a signal in a second band higher than the first band such that the metal pattern and the ground pattern of the PCB are connected to each other in the second band, and
wherein the signal in the second band applied through the feed pattern is radiated through the slot radiator and the second radiator.

11. The antenna module of claim 10, wherein the filter part is configured to pass a signal in a third band higher than the second band such that the metal pattern and the ground pattern of the PCB are connected to each other in the third band, and
wherein the signal in the third band applied through the feed pattern is radiated through the slot radiator.

12. The antenna module of claim 1, wherein the antenna PCB is disposed perpendicular to the PCB, and an end portion of the feed pattern is connected to the transmission line of the PCB through a conductive block coupled to the PCB, and
wherein the ground pattern disposed on at least one side of the feed pattern is connected to a ground of the PCB through the filter part and a conductive block coupled to the PCB.

13. The antenna module of claim 1, wherein the antenna PCB is formed of a dielectric substrate, and the metal pattern is disposed to extend from the one surface of the dielectric substrate to the other surface thereof along a lower surface, and
wherein a hole is disposed on the other surface of the dielectric substrate such that the dielectric substrate is fixed to the PCB through an insertion structure inserted into the hole.

14. The antenna module of claim 1, wherein the antenna PCB is formed of a flexible substrate, and the metal pattern is disposed to extend from the one surface of the flexible substrate to a protruding portion on the other surface thereof along a lower surface, and
wherein the metal pattern is not disposed on a flat portion of the other surface of the flexible substrate.

15. The antenna module of claim 1, wherein the antenna PCB is implemented as a rib structure of a top cover of the antenna module or attached to the rib structure, and disposed to surround inner and outer regions of the rib structure of the metal pattern of the antenna PCB, and the rib structure of the top cover extends to the PCB so as to be coupled to conductive blocks on the PCB.

16. The antenna module of claim 1, wherein a wireless signal is radiated to one surface and the other surface of the antenna PCB at an angle tilted by a predetermined angle in a vertical direction with respect to a bottom surface of a bottom cover of the antenna module, and
wherein the wireless signal is radiated in all directions in a horizontal direction with respect to the bottom surface of the bottom cover.

17. A vehicle having an antenna module, the vehicle comprising:
an antenna module disposed below a roof of the vehicle; and
a processor disposed inside or outside the antenna module, and configured to communicate with at least one of an adjacent vehicle, a road side unit (RSU), and a base station;
wherein the antenna module further comprises:
a PCB having a transmission line disposed thereon;
a bottom cover having the PCB disposed therein, the bottom cover configured to be attached to the vehicle;
an antenna PCB coupled to the PCB, and disposed with a feed pattern on one surface thereof and a metal pattern disposed on at least one of one side and the other side of the feed pattern; and
a filter part configured to electrically connect the metal pattern and a ground pattern of the PCB in a specific band,
wherein the antenna PCB comprises:
a slot radiator configured to radiate a wireless signal through a slot region disposed to have a first length in a first axis direction inside the metal pattern; and
a second radiator connected to an end portion of the feed pattern, and disposed in an upper region of the metal pattern in a second axis direction.

18. The vehicle of claim 17, wherein the slot radiator and the second radiator constitute a radiator module,
wherein the second radiator comprises:
a first region connected to an end portion of the feed pattern, and configured to increase in width in the second axis direction; and
a second region connected to an end portion of the first region in the second axis direction, the second region having a second length in the first axis direction and a second width in the second axis direction, and
wherein the second radiator is configured to radiate a first signal in a first band, the slot radiator and the second radiator are configured to radiate a second signal in a second band higher than the first band, and the slot radiator is configured to radiate a third signal in a third band higher than the second band.

19. The vehicle of claim 17, wherein the processor controls the filter part to block a first signal in a first band such that the metal pattern and the ground pattern of the PCB are not connected to each other in the first band, and controls the filter part to connect the metal pattern and the ground pattern of the PCB in second and third bands higher than the first band such that a second signal in the second band and a third signal in the third band pass therethrough,
wherein the first signal in the first band applied through the feed pattern is radiated through the second radiator, and the second signal in the second band applied through the feed pattern is radiated through the slot radiator and the second radiator, and
wherein the third signal in the third band applied through the feed pattern is radiated through the slot radiator.

20. The vehicle of claim 17, wherein the antenna module comprises a first antenna and a second antenna consisting of the slot radiator and the second radiator, and
wherein the processor controls to perform multi-input multi-output (MIMO) in a first band through the first antenna and the second antenna, and controls to perform multi-input multi-output (MIMO) in a second band and a third band higher than the first band through the first antenna and the second antenna.
